# EUROPÄISCHE PATENTSCHRIFT

(11) **EP 3 588 103 B1**
(45) Veröffentlichungstag und Bekanntmachung des Hinweises auf die Patenterteilung: **07.06.2023**
(21) Anmeldenummer: 19181893.9
(22) Anmeldetag: 24.06.2019
(51) Int. Cl.: G01R 15/18, H01H 83/14, H01H 83/22, H02H 1/00

(54) **MEHRFACHMESSVORRICHTUNG UND LEITUNGSSCHUTZSCHALTER**
MULTIMETER AND CIRCUIT BREAKER
DISPOSITIF DE MESURE MULTIPLE ET DISJONCTEUR DE PROTECTION DE CIRCUIT

(30) Priorität: 28.06.2018 DE 102018115696
(43) Veröffentlichungstag der Anmeldung: 01.01.2020
(73) Patentinhaber: Strip's d.o.o., 1252 Vace (SI)
(72) Erfinder: Smrkolj, Jozef, 1411 Izlake (SI); Jankovec, Danijel, 1252 Vace (SI)
(74) Vertreter: Ter Meer Steinmeister & Partner

(56) Entgegenhaltungen:
- DE-A1- 10 253 018
- GB-A- 2 449 677
- US-A1- 2014 028 116

## Beschreibung

Die vorliegende Erfindung betrifft eine Mehrfachmessvorrichtung mit Stromsensor und Auswerteeinheit sowie einen Schutzschalter mit einer solchen Mehrfachvorrichtung. Eine Mehrfachmessvorrichtung, auch Multimeter oder auch Vielfachmessgerät genannt, ist eine elektrotechnische Messvorrichtung, die für mehrere Messgrößen und in mehreren Messbereichen einsetzbar ist.

Schutzschalter dienen zum selbsttätigen Abschalten von elektrischen Stromkreisen oder einzelnen Verbrauchern bei Überschreiten der zulässigen Strom- oder Spannungswerte, beispielsweise Überstrom, Fehlerstrom.

Ein Schutzschalter trennt dabei den Stromkreis selbsttätig, sobald seine Nennstromstärke um einen bestimmten Faktor überschritten wird. Dies schützt den in der Leitung hinter diesem Schalter befindlichen Verbraucher oder die Leitung vor Beschädigung oder Zerstörung durch die thermische Wirkung des Stroms. Damit der Schutzschalter seine Aufgabe erfüllen kann, umfasst er folgende Funktionsblöcke: Strommessung, Kontaktsystem und Schaltmechanik. Für den Schutz von Leitungen, sind Leitungsschutzschalter, englisch: "miniature circuit breaker", MCB, vorgesehen. Für den Schutz von Geräten sind beispielsweise Motorschutzschalter vorgesehen. Für den Schutz vor gefährlicher Berührungsspannung oder Brandschutz sind Fehlerstromschutzschalter, englisch: "residual-current circuit breaker", kurz RCCB, oder Fehlerspannungsschutzschaltung, englisch: "earth-leakage circuit breaker", kurz ELCB, vorgesehen.

Aus der DE 10 2011 016 933 A1 ist beispielsweise ein Leitungsschutzschalter bekannt, bei dem der Anker eines Magnetauslösers im Störfall über einen Stößel oder Schlagstift den Schaltkontakt des Hauptstrompfads öffnet, so dass der Strom nunmehr nur noch über den Nebenstrompfad und dessen Kontaktstelle fließt. Die Öffnung der Kontaktstelle im Hauptstrompfad erfolgt dabei ohne Bildung eines Lichtbogens, da die Kontaktstelle durch den Nebenstromkreis kurzgeschlossen ist. Beim Auftreten eines Kurzschlussstroms wird die Kontaktstelle des Nebenstrompfads, die als Abbrennkontakt ausgebildet ist, schlagartig vom Stößel oder Schlagstift geöffnet, der hierzu von einem zweiten Anker angetrieben wird. Der bei der Öffnung der Kontaktstelle auftretende Lichtbogen wird in bekannter Weise in einer der Kontaktstelle zugeordneten Deionkammer, auch Lichtbogenlöschkammer genannt, zum Verlöschen gebracht. Da der Abbrennkontakt und ein thermischer Auslöser für den Überstromstörfall im Nebenstrompfad liegen, durch den im störungsfreien Fall kein Strom fließt, lassen sich die Energieverluste im Leitungsschutzschalter im normalen Dauerbetrieb minimieren. Durch den Abbrand am Abbrennkontakt kann sich jedoch die Auslösecharakteristik im Überstromstörfall ändern.

Um Energieverluste in einem normalen Dauerbetrieb zu minimieren und die Ausbildung eines Lichtbogens beim Unterbrechen eines Stromkreises im Kurzschlussfall und damit auch ein Abbrennen von Kontakten weitgehend zu verhindern, wurde in der WO 2016/116559 A1 ein anderer Aufbau für einen Leitungsschutzschalter beschrieben. Darin wird ein Leitungsschutzschalter mit zwei parallel geführten Strompfaden mit je einer Kontaktstelle, die als Haupt- und Nebenstrompfad über eine Kontakteinrichtung mit einer Spule eines Magnetauslösers in Reihe geschaltet sind, beschrieben. Im Nebenstrompfad ist ein Unterbrecher- und Auslöseeinsatz vorgesehen, der im Kurzschlussfall den Nebenstrompfad unterbricht und ein Schaltschloss zur Öffnung und Fixierung der geöffneten Kontakteinrichtung auslöst.

Bisherige Schutzschalter sind nicht in der Lage, Betriebsdaten oder Messwerte auszugeben, einen Störbetrieb zu dokumentieren oder zu alarmieren. Damit sind diese Schutzschalter insbesondere nicht zur Verwendung oder für Anwendungen im Bereich der intelligenten Stromnetze, englisch: "Smart-Grid", geeignet.

Ein Ausschalten des Schutzschalters erfolgt oft plötzlich und ohne Vorwarnung. Eine Ursachenforschung ist wünschenswert. Dazu müssen elektrische Größen während des laufenden Betriebs erfasst, dokumentiert und ausgegeben werden. Zudem wünscht der Netzbetreiber oft einen Kontrollmechanismus, um verbessert elektrische Größen, wie Strom, Spannung, etc. auswerten zu können. Es ist also ein genereller Wunsch, aktuelle Messwerte von Schutzschaltern zu erfassen und auslcscn zu können.

Aus der WO 2015/050506 A1 ist ein multifunktionales Smart-Modul zum Erfassen des Betriebszustandes eines elektrischen Geräts bekannt. Das Smart-Modul erfasst bestimmte Daten, wie Spannungsabfall, Stromstärke, Temperatur, Feuchtigkeit an einem Schutzschalter und ermöglicht die Erkennung einer Änderung des Zustands dieses Schutzschalters. Zudem identifiziert das Smart-Modul, an welchem Schutzschalter die Änderung stattgefunden hat. Das Modul kommuniziert drahtlos über RFID, UHF oder NFC mit einer Überwachungseinheit, um den Betrieb des Schutzschalters und des elektrischen Geräts zu überwachen. Die Energie zum Betreiben des Smart-Moduls wird durch elektromagnetische Wellen der Überwachungseinheit erhalten oder durch eine Batterie im Modul oder über einen Kommunikationskanal bereitgestellt. Das Smart-Modul sammelt dabei nicht nur die Daten, sondern kann drahtlos ferngesteuert ein- oder ausgeschaltet werden.

Aus der WO 2005/101604 A1 ist eine Messvorrichtung bekannt. Diese Vorrichtung umfasst ein drahtloses Kommunikationssystem zur lokalen Übertragung von Informationen, insbesondere über RFID, IR, WiFi, Zigbee oder Bluetooth. Die Informationen betreffen Messungen elektrischer Größen und die Einstellung der für die Schutzfunktionen typischen Parameter oder Diagnoseinformationen, die der Vorrichtung selbst entsprechen. Die Kommunikation erfolgt an eine spezielle computergesteuerte Einheit.

Die GB 2 449 677 A beschreibt ein System zum Identifizieren von Brandrisiken in elektrischen Stromkreisen durch Erkennen einer Lichtbogenbildung und/oder durch Erkennung einer übermäßiger Erwärmung, die durch Spannungsabfälle verursacht werden. Dabei wird jeder Stromverbraucher in einem Hauptstromkreis von Überwachungseinheiten überwacht. In einer Hauptversorgungsleitung eines Ringnetzstromkreises ist in jedem Zweig ein Stromsensor zur Erkennung von elektrischen Teilströmen angeordnet. Wenn die Summe der Teilströme ungleich der Summe der Teilströme der einzelnen Energieverbraucher ist, meldet ein Regler einen Fehlerzustand.

Derartige Messvorrichtungen sind proprietär und können nicht mit bestehenden Schutzschaltern kombiniert werden oder in bereits installierten Verteilerkästen, auch Sicherungskästen genannt, nachgerüstet werden. Die Schutzschalter für Hausinstallationen werden meist in Sicherungskästen mit wenig Platzangebot verbaut. Zudem können diese bekannten Messvorrichtungen in Hausinstallationen ausschließlich Wechselgrößen erfassen. Sie werden zudem nur mittels komplexer Funk- oder Datenverbindungen mit Energie versorgt. Alternativ werden Batterien eingesetzt, die allerdings die Lebensdauer derartiger Messvorrichtungen bedeutend reduzieren.

Weiterhin sind diese Messvorrichtungen nur für eine spezielle Anwendung konzipiert, wodurch die Effizienz und Messgenauigkeit an die Größenordnung der zu erfassenden Messgröße angepasst ist. In einer anderen Anwendung sind derartige Messvorrichtungen dann oft ungenau und ineffizient.

Der Erfindung liegt daher die Aufgabe zugrunde, eine Messvorrichtung bereitzustellen, die kompatibel zu bestehenden Schutzschaltern ist. Zudem sollten sie eine größere Funktionalität aufweisen und energieautark betreibbar sein, um etwaige Energieversorgungs-Abhängigkeit von externen Geräten oder Modulen oder internen Energieversorgungen zu vermeiden. Zur Adaption an bestehende Schutzschalter sollte die Messvorrichtung sehr kompakt und einfach aufgebaut sein und auch für eine hohe Anzahl unterschiedlicher Schutzschalter einsetzbar sein.

Diese Aufgabe wird durch eine Mehrfachmessvorrichtung nach Patentanspruch 1 und einen Leitungsschutzschalter nach Patentanspruch 12 gelöst. Vorteilhafte Ausgestaltungen und Weiterbildungen der Erfindung sind in den Unteransprüchen beschrieben.

Die Aufgabe wird durch eine Mehrfachmessvorrichtung zum Erfassen und Ausgeben mindestens eines elektrischen Messwertes gelöst. Dabei ist einen Stromsensor zum Detektieren eines elektrischen Stroms in Reihenschaltung zwischen einem Eingangskontakt und einem Ausgangskontakt eines Außenleiters angeordnet. Der Eingangskontakt und der Ausgangskontakt sind Kontakte der Messvorrichtung, bevorzugt des Stromsensors. Zudem ist eine elektronische Auswerteeinheit zum Auswerten des detektierten Stromwertes in den auszugebenden Messwert vorgesehen. Diese Auswerteeinheit ist elektrisch kontaktbehaftet verbunden mit einem ersten Anschlusskontakt des Stromsensors, der wiederum mit dem Eingangskontakt elektrisch leitend verbunden ist. Diese Auswerteeinheit ist zudem elektrisch kontaktbehaftet verbunden mit einem zweiten Anschlusskontakt des Stromsensors, der wiederum mit dem Ausgangskontakt elektrisch leitend verbunden ist. Diese Auswerteeinheit ist elektrisch kontaktbehaftet mit einem Neutralleiter verbunden. Kontaktbehaftet bedeutet hier insbesondere, dass sowohl elektrisch als auch mechanisch (physisch) Kontakt zwischen zwei Einheiten besteht.

Die Auswerteeinheit ist eingerichtet zum Umwandeln des detektierten Stromwertes in einen auswertbaren Messwert mittels einer Umwandlungseinheit. Die Umwandlungseinheit ist bevorzugt eine Einheit zum Aufbereiten des mittels Stromsensor detektierten Stromwerts, sodass nachgeschaltete Einheiten den detektierten Stromwert nicht beeinflussen oder gar verfälschen, beispielsweise durch ihren Eingangswiderstand. Dabei erfolgen beispielsweise eine Impedanz-Wandlung und eine Rauschunterdrückung. Zusätzlich kann der detektierte Stromwert digitalisiert werden. Beispielsweise erfolgt ein präzises Digitalisieren des aufbereiteten Stromwert, durch Anwendung einer Delta-Sigma-Wandlung als spezielle Form der Analog-Digital-Wandlung.

Die Auswerteeinheit ist weiter eingerichtet den umgewandelten Stromwert hinsichtlich einer Messaufgabe - also eines auszuwertenden Messwertes - mittels eines Mikrokontrollers auszuwerten. Dabei sind Bcrcchnungsroutincn vorzusehen, um aus dem aufbereiteten Stromwert einen physikalischen oder elektrischen Messwert abzuleiten. Dabei können sowohl Mittelwerte durch entsprechende zeitdiskrete oder kontinuierliche Erfassung als auch Momentanwerte von diesen aufbereiten Stromwerten erhalten werden.

Anschließend erfolgt ein Ausgeben des erhaltenen Messwerts durch die Auswerteeinheit über zumindest eine Kontaktlos-Datenschnittstelle, insbesondere einer breitbandigen Funkverbindung, beispielsweise gemäß Standard Bluetooth 5.0 oder IEEE 802.11 (WLAN) oder über ein Sub-Gigahertz Netzwerk. Diese Kontaktlos-Datenschnittstellen haben eine höhere Reichweite als RFID oder NFC und ermöglichen ein Auslesen der Messwerte trotz großer Distanz zwischen der Mehrfachmessvorrichtung und einer externen Einheit, zum Empfangen des Messwertes. Diese Kontaktlos-Datenschnittstelle ermöglicht insbesondere das Übertragen des Messwertes über eine Luftdatenschnittstelle. Kontaktlos, auch als drahtlos bezeichnet, bedeutet hierbei, dass die Datenkommunikation zumindest teilweise über Luft erfolgt, also beispielsweise funkbasiert, optisch oder über induktive Kopplung.

Der auszugebende Messwert wird in Form von digitalen Daten an eine externe Einheit über diese Kontaktlos-Datenschnittstelle gesendet. Über diese Kontaktlos-Datenschnittstelle können zudem auch Daten von einer externen Einheit an die Auswerteeinheit übertragen werden, beispielsweise eine Aktualisierungs-Routine für die Auswerteeinheit, eine Diagnoseanfrage und/oder eine verbesserte Berechnungsroutine zum Auswerten des aufbereiteten Stromwerts.

Bevorzugt erfolgt das Ausgeben des Messwertes über eine Identifizierung der Mehrfachmessvorrichtung, beispielsweise über eine eindeutige Identifizierungsnummer oder eine fest zugeordnete Netzwerkadresse oder eine Chip-ID der Auswerteeinheit.

Zusätzlich kann auch eine kontaktbehaftete Datenschnittstelle in der Auswerteeinheit vorgesehen sein. Diese kontaktbehaftete Datenschnittstelle dient zum Ausgeben des ausgewerteten Messwerts oder Empfangen von Daten zur Auswertung mittels der Auswerteeinheit. Diese kontaktbehaftete Datenschnittstelle dient einerseits zum Empfangen von detektierten Stromwerten, beispielsweise von einem Schutzschalter. Auf diese Weise kann ein mittels eines Stromsensors bereits detektierter Stromwert auch von der Mehrfachmessvorrichtung umgewandelt, ausgewertet und ausgegeben werden. Anderseits können die umgewandelten Stromwerte auch einer der Mehrfachmessvorrichtung nachgelagerten Einheit, beispielsweise einem Schutzschalter oder einer Überwachungseinheit, zur Verfügung gestellt werden. Somit kann die Funktionalität eines bestehenden Schutzschalters erhöht werden, indem die vorgeschaltete Mehrfachmessvorrichtung einen Messwert permanent oder nur in ungewöhnlichen Betriebsfällen, beispielsweise als Fehlerstromwert oder Überstromwert oder erhöhtem Temperaturwert, an die nachgelagerte Einheit berichtet, woraufhin diese entsprechenden Schutzmaßnahmen, beispielsweise Abschalten, ausführt. Die kontaktbehaftete Datenschnittstelle kann auch Statusinformationen vom Schutzschalter erhalten und diese werden mittels der Auswerteeinheit ausgegeben. Eine kontaktbehaftete Datenschnittstelle wird auch als drahtgebundene Datenschnittstelle bezeichnet.

Von der Messvorrichtung können vollständig ausgewertete Messwerte in einer externen Einheit erhalten werden, die mittels der Kontaktlos-Datenschnittstelle zur externen Einheit, beispielsweise Geräte wie Smartphone, Laptop, Tablet übermittelt und dort prompt angezeigt werden können. Dazu kann eine Applikation auf der externen Einheit verwendet werden, die die ausgegebenen Daten direkt anzeigt. Die externe Einheit kann zudem ein Gateway sein, über dieses die Daten mit einem entfernten Server, beispielsweise einem Stromanbieter kommuniziert werden.

Alternativ dient die externe Einheit nur als Messwerte-Sammeleinheit, beispielsweise zur Abgabe eines Stromverbrauchberichts als intelligenter Stromverbrauchszähler. Durch das sofortige Umwandeln, Auswerten und Ausgeben in der Messvorrichtung werden Verluste aufgrund Datenübertragungen von Zwischenergebnissen verhindert und so die Genauigkeit bei der Erfassung erhöht.

Zudem wird durch die elektrische Verbindung mit dem Neutralleiter der Auswerteeinheit eine Spannungsdifferenz zwischen Außenleiter und Neutralleiter bereitgestellt. Diese Spannungsdifferenz dient einerseits zur Energiegewinnung, um die Auswerteeinheit zu betreiben und andererseits kann so ein Spannungswert detektiert werden. Dieser Spannungswert wird ebenfalls mittels Auswerteeinheit umgewandelt, ausgewertet und ausgegeben.

Somit wird die Energie zum Betreiben der Auswerteeinheit aus einer Spannungsdifferenz zwischen den Potenzialen des Außenleiters und des Neutralleiters erhalten. Auf diese Weise ist keine zusätzliche Energieversorgung bereitzustellen und die Mehrfachmessvorrichtung wird energieautark betrieben, insbesondere ohne eigene Energieversorgung und ohne Energieversorgung aus Kommunikationsprotokollen mit externen Einheiten.

Durch das erfindungsgemäße elektrische Verbinden des Neutralleiters mit der Auswerteeinheit können nun Spannungswerte sehr einfach erfasst werden und auch Gleichanteile im detektierten Stromwert oder die Richtung des Stromflusses detektiert werden. Somit können neben Wechselgrößen auch Gleichgrößen ermittelt und ausgewertet werden.

Die Auswerteeinheit ist insbesondere dazu eingerichtet, den detektierten Stromwert in einen auszugebenden elektrischen Stromwert durch den Außenleiter oder einen Spannungswert zwischen Außenleiter und Neutralleiter als Messwert zu wandeln. Dabei können charakteristische Wechselstromwerte oder Wechselspannungswerte ausgewertet werden, beispielsweise ein Effektivwert des Stromes oder der Spannung, englisch Root-Mean-Square oder auch True-Root-Mean-Square oder der Gleichrichtwert. Beispielsweise erfolgt dazu die Aufzeichnung einer Wechselgröße über mindestens eine Periode der Wechselgröße, bevorzugt ein Aufzeichnen einer Vielzahl von Perioden, und anschließendes Berechnen mittels in der Auswerteeinrichtung, beispielsweise einem Mikrokontroller oder Signalprozessor, hinterlegter Berechnungsroutinen, wie arithmetische/quadratische Mittelwertberechnung etc. Zusätzlich oder alternativ können Stromspitzenwerte, Strom-Spitze-Spitze-Werte, ein Gleichstromanteil, harmonische Verzerrungen, englisch: "Total Harmonics Distortion", kurz THD, erfasst werden. Diese THD können bis zur 32. harmonischen Schwingung erfasst werden. Hier können insbesondere ein-phasige Strom-Spannungswerte erfasst werden. In einer mehr-phasigen Betriebsanlage sind zudem auch Auswertungen zwischen zwei oder mehr Außenleitern denkbar.

Der detektierte Strom- und/oder Spannungswert kann demnach ein Gleichstromwert (DC) oder ein Wechselspannungswert (AC) oder ein Mischspannungswert (AC+DC) sein, der von der Auswerteeinheit als Messwert ausgegeben wird.

Die Auswerteeinheit ist insbesondere dazu eingerichtet, den detektierten Strom und/oder Spannungswert hinsichtlich eines auszugebenden Richtungswert durch den Außenleiter als Messwert auszugeben. Das Kontaktieren des Neutralleiters und des Außenleiters ermöglicht das Erfassen der Richtung eines Stroms oder Spannung aufgrund des Vorzeichens des erfassten Strom- oder Spannungswertes durch den Außenleiter.

Die Auswerteeinheit ist insbesondere dazu eingerichtet, aus dem detektierten Stromwert und/oder dem detektierten Spannungswert einen auszugebenden Leistungswert durch den Außenleiter als Messwert zu wandeln. Dabei sind sowohl Wirkleistungswerte, Blindleistungswerte und Scheinleistungswerte auswertbar. Zudem kann ein Leistungsfaktor (cos(phi)) ausgegeben werden.

Die Auswerteeinheit ist insbesondere dazu eingerichtet, aus dem detektierten Stromwert und dem detektierten Spannungswert einen auszugebenden Energiewert durch den Außenleiter als Messwert zu wandeln. Dabei sind sowohl Wirkcncrgicwcrtc, Blindcncrgicwcrtc und Scheinenergiewerte erfassbar.

Die Auswerteeinheit ist weiterhin insbesondere dazu eingerichtet, aus dem detektierten Stromwert oder dem detektierten Spannungswert einen auszugebenden Frequenzwert einer elektrischen Messgröße durch den Außenleiter als Messwert zu wandeln.

Die Auswerteeinheit ist auch dazu eingerichtet, aus dem detektierten Stromwert oder dem detektierten Spannungswert einen auszugebenden Temperaturwert einer elektrischen Messgröße durch den Außenleiter als Messwert zu wandeln und auszugeben.

Die auszugebenden Messwerte können simultan über die Kontaktlos-Datenschnittstelle ausgegeben werden oder gesammelt werden und als Datensatz gebündelt ausgegeben werden.

Bevorzugt umfasst der Stromsensor ein plattenförmiges Widerstandselement. Damit ist der Stromsensor ein Shunt-Widerstand. Das Material des plattenförmigen Widerstandselements ist bevorzugt zumindest teilweise eine Kupfer-Nickel-Mangan-Legierung, auch als Manganin bezeichnet. Diese Widerstandslegierung hat einen sehr niedrigen mittleren spezifischen elektrischen Widerstand und eine sehr geringe Temperaturabhängigkeit. Zudem hält das Material Hochstromimpulsen im Kilo-Ampere-Bereich für mehrere Millisekunden stand. Somit ist die Effizienz der Mehrfachmessvorrichtung erhöht und etwaige Energieverluste werden minimiert. Alternativ kann Konstantan als Material verwendet werden, welches eine höhere Umweltrobustheit aufweist.

Der Stromsensor umfasst zudem ein erstes abgewinkeltes Anschlusselement, bevorzugt aus Kupfer. Dieses erste abgewinkelte Anschlusselement ist mit seinem ersten Ende mit einer ersten Seite des Widerstandselements verschweißt. Der erste Anschlusskontakt ist an einem zweiten Ende des ersten Anschlusselements angeordnet. Das zweite Ende des ersten Anschlusselements ist vom ersten Ende des ersten Anschlusselements entfernt, beispielsweise gegenüberliegend.

Der Stromsensor umfasst bevorzugt ein zweites abgewinkeltes Anschlusselement, bevorzugt aus Kupfer. Dieses zweite abgewinkelte Anschlusselement ist mit seinem zweiten Ende mit einer zweiten Seite des Widerstandselements verschweißt. Die zweite Seite des Widerstandselements ist von der ersten Seite des Widerstandselements entfernt, bevorzugt gegenüberliegend. Der zweite Anschlusskontakt ist an einem, dem zweiten Ende des zweiten Anschlusselements angeordnet. Das zweite Ende des zweiten Anschlusselements ist vom ersten Ende des zweiten Anschlusselements entfernt, beispielsweise gegenüberliegend.

Liegen die zu detektierenden Stromwerte im Kilo-Ampere-Bereich, so muss der Stromsensor eine entsprechende Stromfestigkeit aufweisen. Der Stromsensor muss dann eine entsprechende Baugröße aufweisen, die dann der limitierende Platzfaktor in der Mehrfachmessvorrichtung ist. Das Abwinkeln zumindest eines der Anschlusselements ermöglicht eine kompaktere Ausgestaltung des Stromsensors, da der Stromsensor nun nicht zwingend in einer Ebene ausgebreitet ist. Die geforderte Stromfestigkeit bleibt dabei erhalten. Dabei ist das Widerstandselement weiterhin plattenförmig und die beiden Anschlusskontakte des Stromsensors können abgewinkelt dazu angeordnet werden.

Am Stromsensor ist bevorzugt zudem ein erstes Kontaktfahnenelement ausgebildet, bevorzugt aus Kupfer. Das Kontaktfahnenelement weist den Eingangskontakt auf und ist mechanisch mit dem ersten abgewinkelten Anschlusselement verbunden. Am Stromsensor ist bevorzugt auch ein zweites Kontaktfahnenelement ausgebildet, bevorzugt aus Kupfer. Das zweite Kontaktfahnenelement weist den Ausgangskontakt auf und ist mechanisch mit dem zweiten abgewinkelten Anschlusselement verbunden. Dazu können Verbindungsbolzen vorgesehen sein, sodass ein Vernieten oder Verschweißen des Kontaktfahnenelements mit dem Anschlusselement vereinfacht möglich ist. Das Kontaktfahnenelement kann selbst wiederum abgewinkelt sein, um platzsparend in der Mehrfachmessvorrichtung untergebracht zu sein. Zudem können winklige Kontaktfahnenelemente den Stromsensor stabil in einem Gehäuse der Mehrfachmessvorrichtung halten.

Bevorzugt hat die Mehrfachmessvorrichtung ein Gehäuse zum Schutz vor Umwelteinflüssen und als Schutz vor Berührung von stromführenden Elementen durch einen Menschen. Das Gehäuse umfasst dabei ein Mittelteil zum Aufnehmen der Auswerteeinheit und des Stromsensors. Dazu sind Abstufungen im Mittelteil vorgesehen, die die Auswerteeinheit zumindest punktuell aufnehmen. Das Gehäuse weist zudem bevorzugt eine erste Seitenabdeckung zum Abdecken einer ersten Seite der Auswerteeinheit und eine zweite Seitenabdeckung zum Abdecken einer zweiten Seite der Auswerteeinheit auf. Die Seitenabdeckungen können Fixierelemente oder Vorsprünge aufweisen, um die Auswerteeinheit im Gehäuse zu fixieren, beispielsweise im Zusammenspiel mit den Abstufungen des Mittelteils. Die Seitenabdeckungen ermöglichen einen Schutz vor Berührung stromführender Elemente der Mehrfachmessvorrichtung, allerdings auch einen Wartungszugang zu Diagnosezwecken der Mehrfachmessvorrichtung.

Bevorzugt nimmt das Mittelteil eine erste Leiterplatine aufweisend einen ersten Teil der Auswerteeinheit auf. Zudem nimmt das Mittelteil eine zweite Leiterplatine aufweisend einen zweiten Teil der Auswerteeinheit auf. Die erste Leiterplatine ist mit der zweiten Leiterplatine über zumindest ein Verbindungselement elektrisch verbunden.

Diese Teilung der Auswerteeinheit ermöglicht eine Trennung funktionell verschiedener Untereinheiten der Auswerteeinheit. Beispielsweise ist auf der ersten Leiterplatine eine Energieversorgungseinheit der Auswerteeinheit, kontaktierend den Außenleiter und den Neutralleiter, untergebracht. Auf der zweiten Leiterplatine ist sodann die Umwandlungseinheit und die Kontaktlos-Datenschnittstelle untergebracht. Damit können sich beeinflussende Elemente, beispielsweise eine Energieversorgungseinheit und die Umwandlungseinheit ausreichend beabstandet voneinander im Gehäuse untergebracht werden und so die Messgenauigkeit als auch die Sendeeigenschaft stark verbessert werden. Zudem kann ein Hochstrombereich von einem Niederstrombereich sehr einfach isoliert werden, um Sicherheitsbestimmungen zu erfüllen.

Zwischen der ersten Leiterplatine und der zweiten Leiterplatine wird bevorzugt der Stromsensor angeordnet. Damit sind die erste Leiterplatine und die zweite Leiterplatine bevorzugt voneinander weiter beabstandet, um eine gegenseitige Beeinflussung funktional getrennter Einheiten der Auswerteeinheit weiter zu reduzieren. Dies ermöglicht einen kompakten Aufbau und reduziert den Platzbedarf erheblich.

Bevorzugt weist die Mehrfachmessvorrichtung eine Schraubhalterung zum lösbaren Verbinden des Außenleiters am Eingangskontakt. Zudem ist bevorzugt eine Klemmhalterung zum mechanisch lösbaren Kontaktieren der Auswerteeinheit mit dem Neutralleiter vorgesehen. Damit wird einfaches Installieren der Mehrfachmessvorrichtung in bestehende Stromleiter-Installationen ermöglicht.

Bevorzugt ist der Ausgangskontakt elektrisch mit einem Außenleiter-Eingangskontakt eines Schutzschalters verbindbar, wobei ein elektrisches Kontaktieren des Ausgangskontakts mit dem Eingangskontakt des Schutzschalters bevorzugt mechanisch lösbar mittels einer Schraubhalterung des Schutzschalters erfolgt. Dies ermöglicht eine einfache Nachrüstung bestehender Schutzschalter mit der Mehrfachmessvorrichtung. Die Schutzschalter sind insbesondere Leitungsschutzschalter (MCB oder MCCB) oder Fehlerschutzschalter (RCD, RCCB) oder eine Kombination aus beidem (RCBO, ELCB). Da zumindest der Außenleiter dem Schutzschalter zuzuführen ist, kann nun dieser Außenleiter mit dem Eingangskontakt der Mehrfachmessvorrichtung und der Ausgangskontakt der Mehrfachmessvorrichtung mit dem Eingangskontakt des Schutzschalters verbunden werden. Aufgrund standardisierten Gehäuseformen der Schutzschalter, beispielsweise nach VDE 0100-430 oder VDE 0641-11 (EN-60898), ist die Installation problemlos möglich.

Die Aufteilung der Auswerteeinheit ermöglicht zudem einen Einsatz der Mehrfachmessvorrichtung in einer Vielzahl unterschiedlicher Anwendungen, wobei diese Auswerteeinheit verschiedenste Strombereiche abdeckt und lediglich der Stromsensor an die jeweiligen Strombereiche anzupassen ist.

Bevorzugt können benachbarte Leitungsschalter jeweils eine Mehrfachmessvorrichtung aufweisen, wobei der elektrische Kontakt zum Neutralleiter mittels einer Neutralleiter-Brücke von einer ersten Mehrfachmessvorrichtung zur benachbarten zweiten Mehrfachmessvorrichtung erfolgt. Auf diese Weise muss der Neutralleiter nicht zu jeder Mehrfachmessvorrichtung geführt werden, was insbesondere bei der Nachrüstung von Leitungsschutzschaltern vorteilhaft ist.

In einem weiteren Aspekt wird die Aufgabe durch einen Schutzschalter gelöst, der eine Mehrfachmessvorrichtung der vorhergehend beschriebenen Art umfasst. Die Mehrfachmessvorrichtung ist beispielsweise als Zusatzmodul mit dem Schutzschalter verbindbar, sodass bestehende Installationen lediglich um die Funktionen der Mehrfachmessvorrichtung erweitert werden. Dabei ist die Mehrfachmessvorrichtung eine eigenständige Einheit.

Alternativ oder zusätzlich kann eine Mehrfachmessvorrichtung auch integraler Bestandteil eines Schutzschalters sein, sodass Schutzschalter und Mehrfachmessvorrichtung ein gemeinsames Gehäuse teilen. Das damit erhaltene Schutzgerät kann z.B. ein Hybridgerät sein, das die Funktionalität eines Schutzschalters und die klassische Schmelzsicherung vereint. Die Mehrfachmessvorrichtung in diesem Schutzgerät hat dann auch die Funktion als Bimetall-Emulators und löst einen Magneten aus und schaltet die Stromzufuhr ab, wenn ein Überstrom detektiert wird.

Zusätzlich oder alternativ kann das Mehrfachmessgerät ein 3-Phasen-Multimeter sein. Anstelle eines Shunt-Widerstands als Stromsensor kann ein Stromtransformator, english: current transformer oder eine Rogowski-Spule verwendet werden.

Durch Anwendung einer Kontaktlos-Datenschnittstelle kann nun nicht nur zuverlässig ein Störungsfall an eine externe Einheit gemeldet (alarmiert) werden, es kann überdies eine Stromrichtung im Außenleiter und auch eine Identifizierung einer Messvorrichtung an die externe Einheit gemeldet werden. Die Messvorrichtung ist dabei bevorzugt modular mit einem Schutzschalter verbunden. Zudem kann auch der Zustand eines Schutzschalters mittels der externen Einheit fernüberwacht werden. Dies ermöglicht die Anwendung im Bereich der "intelligenten Stromnetze". Diese umfassen die kommunikative Vernetzung und Steuerung von Stromerzeugern, Speichern, elektrischen Verbrauchern und Netzbetriebsmitteln in Energieübertragungs- und -verteilungsnetzen der Elektrizitätsversorgung. Erfindungsgemäß wird nun eine Optimierung und Überwachung der miteinander verbundenen Bestandteile im Energienetz ermöglicht und ein effizientes und zuverlässiges System betrieben.

Bevorzugt weist der Schutzschalter zwei parallel geführte Strompfade auf, die als Haupt-und Nebenstrompfad über eine Kontakteinrichtung in Reihe zu einer Spule eines Magnetauslösers geschaltet sind. Im Störungsfall löst ein Schaltschloss zur Öffnung und Fixierung der Kontakteinrichtung aus, um einen gemeinsamen Schaltkontakt der Kontakteinrichtung zu öffnen, um den Haupt- und den Nebenstrompfad zu unterbrechen. So kann der Stromkreis komplett unterbrochen werden und ein Stromfluss gestoppt werden. Damit werden primär Stromleitungen zu einer Hausinstallation oder für eine Hausinstallation und sekundär ein angeschlossener Stromverbraucher im Störungsfall vor einem Überstrombetrieb geschützt.

Der Magnetauslöser öffnet im Kurzschlussfall einen anderen Schaltkontakt der Kontakteinrichtung, um ausschließlich den Hauptstrompfad zu unterbrechen. Im Nebenstrompfad ist ein Unterbrecher- und Auslöseeinsatz angeordnet, der im Kurzschlussfall den Nebenstrompfad unterbricht und das Schaltschloss zur Öffnung und Fixierung der Kontakteinrichtung auslöst, um den gemeinsamen Schaltkontakt für den Haupt- und den Nebenstrompfad zu unterbrechen. Der Stromsensor ist dabei in Reihe zu der Spule und der Kontakteinrichtung geschaltet. Erfindungsgemäß werden also die Funktionen einer Hausanschluss-Sicherung mit der Trennvorrichtung und einer Messvorrichtung in einem kompakten Schutzschalter kombiniert.

Insbesondere wird durch diese Anordnung eines Unterbrecher- und Auslöseeinsatzes erreicht, dass im Kurzschlussfall nur der andere Schaltkontakt des Hauptstrompfads, der als sogenannter Leerkontakt den Betriebsstrom führt, ohne Unterbrechung des Kurzschlussstroms geöffnet wird. Der Kurzschlussstrom wird so auf den Nebenstrompfad und damit durch den Unterbrecher- und Auslöseeinsatz geleitet. Dabei tritt kein Lichtbogen im Hauptstrompfad auf und die Schaltkontakte bleiben im Kurzschlussfall unversehrt. Der Unterbrecher- und Auslöseeinsatz unterbricht dann den Nebenstrompfad, ohne dass es an dem gemeinsamen Schaltkontakt oder dem anderen Schaltkontakt zu einem Lichtbogen kommt.

Die Kontakteinrichtung besteht demnach aus einem gemeinsamen Schaltkontakt, der gleichzeitig den Haupt- und den Nebenstrompfad unterbricht und einem anderen Schaltkontakt der ausschließlich den Hauptstrompfad unterbricht. Diese Kontakteinrichtung ermöglicht die Umleitung in den Nebenstrompfad im Kurzschlussfall sowie das prompte Unterbrechen - also Öffnen - beider parallelen Strompfade und somit eine prompte Auftrennung des Stromkreises im Störungsfall auf mechanisch und elektrisch einfache Weise, sodass die Fehleranfälligkeit reduziert und die Langlebigkeit erhöht wird.

Der Stromsensor erfasst den Strom im Hauptstrompfad permanent und die Auswerte-Einheit ist dazu vorgesehen, den detektierten Stromwert auszuwerten, um den Störungsfall zu erkennen, wobei im Störungsfall der detektierte Stromwert oberhalb eines definierten Vielfachen eines Nennstroms für eine vordefinierte Zeitspanne liegt. Im Störungsfall liegt ein erfasster Stromwert - also ein Ist-Stromwert - oberhalb eines Referenzstromwertes - also oberhalb eines Sollstromwertes. Beispielsweise ist der Referenzstromwert ein definiertes Vielfaches eines Nennstroms für eine vordefinierte Zeitspanne. Durch eine kontinuierliche Überwachung des Stromwertes im Leitungsschutzschalter, beispielsweise durch ein Erfassen eines Stromwertes in bestimmten Zeitabständen, kann überwacht werden, ob ein gewünschter Nennstromwert signifikant überschritten wird. Hält dieses Überschreiten des Stromwertes länger an als eine vordefinierte Zeitspanne, so wird ein Störungsfall erkannt und Haupt- und Nebenstrompfad durch das Öffnen des gemeinsamen Schaltkontakts unterbrochen. Somit kann ein Schaden an den Leitungen und ggf. auch am Stromverbraucher vermieden werden und Sicherheitsbestimmungen für eine Elektroinstallation, beispielsweise verlegte Leitungen in einem Gebäude, etc. werden eingehalten. Der Stromsollwert darf in diesem Fall nicht zu hoch gewählt werden, also beispielsweise nur doppelt so groß, wie der Ist-Stromwert sein, falls der gemeinsame Schaltkontakt stromführend geöffnet wird, um einen Kontaktabbrand zu verhindern.

Die Auswerte-Einheit überwacht in bestimmten Zeitabständen den detektierten Stromwert des Hauptstrompfades und vergleicht diesen mit einem Referenzstromwert, bevorzugt einem vordefinierten Vielfachen eines Nennstromwerts. Dies ermöglicht eine genaue Stromerfassung und Überwachung. Diese Stromüberwachung kann dabei in kontinuierlicher Weise erfolgen, also während des gesamten Betriebs des Leitungsschutzschalters. Die Zeitdauer zwischen den Zeitabständen ist dabei veränderbar.

Die Auswerte-Einheit steuert im detektierten Störungsfall einen Auslöseschalter - auch als Trigger bezeichnet - an, mit dessen Aktivierung das Schaltschloss zur Öffnung und Fixierung der Kontakteinrichtung auslöst. Dessen Aktivierung löst sodann das Schaltschloss zur Öffnung und Fixierung der Kontakteinrichtung aus. Auf diese Weise erfolgt ein elektronisch gesteuertes Erfassen und Überwachen eines aktuellen Stromwertes (Ist-Stromwert). Entsprechend einer definierten Vorgabe wird so zuverlässig der Störungsfall detektiert und entsprechend das Schaltschloss aktiviert, um den gemeinsamen Schaltkontakt der Kontakteinrichtung zu öffnen. Auf diese Weise wird der Nebenstrompfad auch durch die Kontakteinrichtung geöffnet, um ein zuverlässiges Unterbrechen des Stromkreises zu ermöglichen, beispielsweise für den Fall, dass der Unterbrecher- und Auslöseeinsatz den Nebenstrompfad in fehlerhafter Weise nicht unterbrechen sollte.

Die Auswerte-Einheit erfasst einen Status des Schaltschlosses, einen Status des Unterbrecher- und Auslöseeinsatzes und die Schaltstellung der Kontakteinrichtung - beispielsweise über eine kontaktbehaftete Datenschnittstelle mit dem Schutzschalter oder durch direkte Verdrahtung, bei Unterbringung von Messvorrichtung und Schutzschalter in einem Gehäuse - und gibt diese über die Kontaktlos-Datenschnittstelle aus.

### KURZBESCHREIBUNG DER ZEICHNUNGEN

Die Erfindung wird im Folgenden beispielsweise anhand der Zeichnung näher erläutert. Es zeigen:
Fig. 1 ein Prinzip-Schaltbild einer Mehrfachmessvorrichtung gemäß einem Ausführungsbeispiel der vorliegenden Erfindung mit optional nachgeschaltetem Schutzschalter,
Fig.2 ein detaillierteres Übersichts-Blockschaltbild der Mehrfachmessvorrichtung gemäß dem Ausführungsbeispiel der Fig.1,
Fig.3 ein detaillierteres Schaltbild einer Energieversorgungseinheit der Mehrfachmessvorrichtung gemäß dem Blockschaltbild der Fig.2,
Fig.4 ein detaillierteres Schaltbild eines Mikrokontrollers, einer Kontaktlos-Datenschnittstelle, einer Antenne, einer Signalisierungseinheit und einer SPI- Datenschnittstelle der Mehrfachmessvorrichtung gemäß dem Blockschaltbild der Fig.2,
Fig.5 ein detaillierteres Schaltbild einer Umwandlungseinheit, einer weiteren Energieversorgungseinheit und eines Verbindungselements der Mehrfachmessvorrichtung gemäß dem Blockschaltbild der Fig.2,
Fig.6 eine dreidimensionale perspektivische Darstellung einer zerlegten Mehrfachmessvorrichtung gemäß einem Ausführungsbeispiel der vorliegenden Erfindung (4. Variante),
Fig.7a bis 7c verschiedene dreidimensionale perspektivische Darstellungen der Mehrfachmessvorrichtung gemäß Fig.6 (4. Variante),
Fig.8a bis 8c verschiedene dreidimensionale perspektivische Schnittdarstellungen der Mehrfachmessvorrichtung gemäß Fig.6 und Fig.7a bis 7c (4. Variante),
Fig. 9 eine dreidimensionale perspektivische Darstellung eines Ausführungsbeispiels eines Systems aus erfindungsgemäßen Mehrfachmessvorrichtung gemäß Fig.1 und Schutzschalter im getrennten Zustand (4. Variante),
Fig. 10a eine dreidimensionale perspektivische Darstellung des Ausführungsbeispiels eines Systems gemäß Fig.9 im verbundenen Zustand (4. Variante),
Fig. 10b eine dreidimensionale perspektivische Schnittdarstellung des Ausführungsbeispiels eines Systems gemäß Fig.9 und Fig.10a im verbundenen Zustand (4. Variante),
Fig. 11 eine dreidimensionale perspektivische Darstellung eines Verbunds aus zwei Systemen gemäß dem Ausführungsbeispiel gemäß Fig.9 und Fig.10a im verbundenen Zustand mit Neutralleiterbrücke (4. Variante),
Fig. 12a bis 12c verschiedene dreidimensionale perspektivische Darstellungen eines Ausführungsbeispiels eines erfindungsgemäßen Stromsensors für eine Mehrfachmessvorrichtung gemäß der Fig. 1, 2, 6 bis 11 (4. Variante),
Fig.13a bis 13b eine dreidimensionale perspektivische Darstellung eines Ausführungsbeispiels einer Mehrfachmessvorrichtung gemäß der vorliegenden Erfindung (1. Variante),
Fig. 14 ein Schaltbild eines Leitungsschutzschalters gemäß einem Ausführungsbeispiel der vorliegenden Erfindung im eingeschalteten Zustand im störungsfreien Betrieb (2. Variante),
Fig. 15 ein Schaltbild des Leitungsschutzschalters gemäß dem Ausführungsbeispiel der vorliegenden Erfindung im ausgeschalteten Zustand nach Auftreten eines Störungsfalls (2. Variante), und
Fig. 16 ein Schaltbild des Leitungsschutzschalters gemäß dem Ausführungsbeispiel der vorliegenden Erfindung im eingeschalteten Zustand im Kurzschlussfall (3. Variante).

In den verschiedenen Figuren der Zeichnung sind einander entsprechende Bauteile bzw. die gleiche Funktion aufweisende Bauelemente mit gleichen Bezugszeichen versehen.

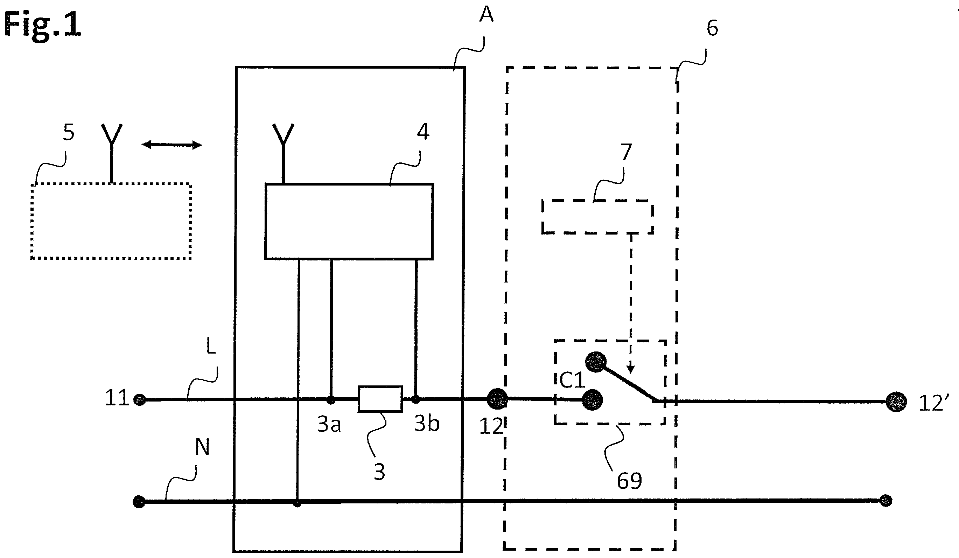

In Fig. 1 ist ein Prinzip-Schaltbild einer Mehrfachmessvorrichtung A gemäß einem Ausführungsbeispiel der vorliegenden Erfindung mit optional nachgeschaltetem Schutzschalter 6 dargestellt.

Die Mehrfachmessvorrichtung A weist einen Stromsensor 3 und eine Auswerteeinheit 4 auf. Der Stromsensor 3 weist einen ersten Anschlusskontakt 3a auf, der elektrisch in Reihe mit einem Eingangskontakt 11 der Messvorrichtung A verbunden ist. Der Stromsensor 3 weist einen zweiten Anschlusskontakt 3b auf, der elektrisch in Reihe mit einem Ausgangskontakt 12 der Messvorrichtung A verbunden ist.

An den Eingangskontakt 11 wird ein Außenleiter L, englisch: "line conductor", einer Elektroinstallation angeschlossen. Der Außenleiter L, umgangssprachlich "Phase", ist ein Leiter, der im üblichen Betrieb unter Spannung steht (= also eine Potentialdifferenz zu einem Neutralleiter aufweist) und zur Übertragung oder Verteilung elektrischer Energie beiträgt. Bei einphasigen Anschlüssen mit einer Nennspannung von 230 V tritt er nur einfach auf und wird mit L bezeichnet. Bei Dreiphasenanschlüssen gibt es drei Außenleiter, die mit L1, L2 und L3 bezeichnet werden.

Die Anschlusskontakte 3a, 3b des Stromsensors 3 sind mit der Auswerteeinheit 4 verbunden. Zudem ist die Auswerteeinheit 4 mit einem Neutralleiter N elektrisch leitend verbunden. Die Energie zum Betreiben der Auswerteeinheit 4 wird aus der Potentialdifferenz zwischen dem Potenzial des Außenleiters L und des Neutralleiters N in einer Energieversorgungseinheit (nicht dargestellt) der Auswerteeinheit 4 erhalten. Zudem kann durch die Verbindung mit dem Neutralleiter ein Spannungswert zwischen L und N von der Auswerteeinheit detektiert werden.

Die Auswerteeinheit 4 ist zum Umwandeln eines vom Stromsensor 3 detektierten Strom-und/oder Spannungswertes in einen auswertbaren Messwert und zum Auswerten des auswertbaren Messwerts mittels einer Umwandlungseinheit (nicht dargestellt in Fig.1) vorgesehen. Zudem gibt die Auswerteeinheit 4 den ausgewerteten Messwert zumindest mittels einer Kontaktlos-Datenschnittstelle (nicht dargestellt in Fig.1) an eine externe Einheit 5 aus.

Eine Stromdetektion erfolgt mittels des Stromsensors 3, eine Spannungsdetektion erfolgt beispielsweise mittels Spannungsteilern (nicht dargestellt in Fig.1). Die detektierten elektrischen Größen werden mittels der Auswerteeinheit 4 umgewandelt und ausgewertet und ausgegeben. Dazu stehen beispielsweise in der Auswerteeinheit 4 Speicherregister zur Verfügung, welche ausgelesen werden und beispielsweise über Bluetooth 5 als Kontaktlos-Datenschnittstelle (nicht dargestellt in Fig.1) der externen Einheit 5 zur Verfügung gestellt werden.

Der Messvorrichtung A ist ein Schutzschalter 6 nachgeschaltet. Der Schutzschalter 6 hat einen Eingangskontakt für einen Außenleiter L und hat einen Auslöseschalter 7, um eine Kontakteinrichtung 69 anzusteuern. Die Kontakteinrichtung 69 hat einen Kontakt C1, der im Störfall oder Fehlerfall öffnet, um einen an den Ausgangskontakt 12' angeschlossenen Verbraucher vor einem Überstrom zu schützen.

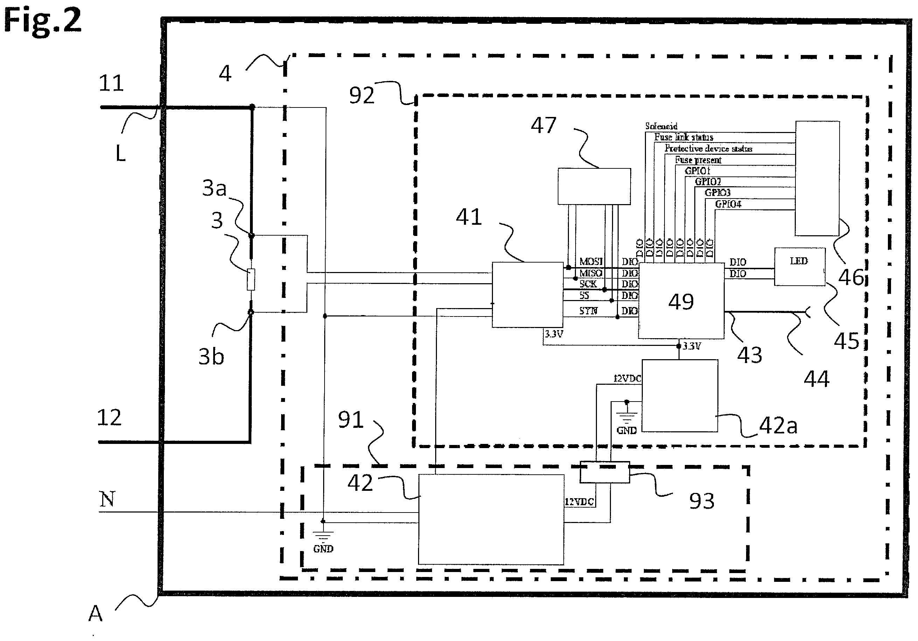

In Fig.2 ist ein detaillierteres Übersichts-Blockschaltbild der Mehrfachmessvorrichtung A gemäß dem Ausführungsbeispiel der Fig.1 dargestellt, wobei die Auswerteeinheit 4 detaillierter dargestellt ist.

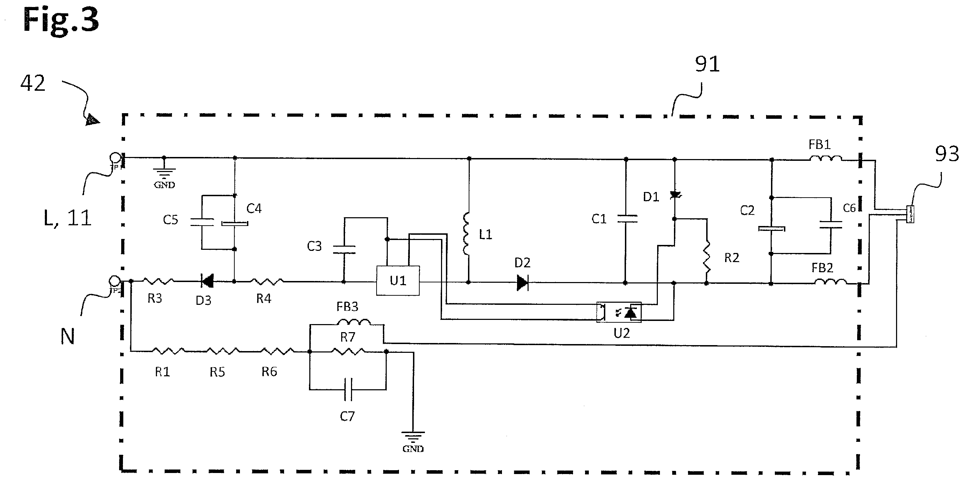

Die Auswerteeinheit 4 umfasst die in Fig.1 bereits erwähnte Energieversorgungseinheit 42, welche eingangsseitig mit dem Neutralleiter N und dem Außenleiter L verbunden ist, um aus dem Potentialunterschied zwischen N und L eine Versorgungsspannung zu generieren und diese - über das Verbindungselement 93 - an die weiteren Untereinheiten 41 und 43 bis 47 der Auswerteeinheit 4 weiterzugeben. Die Energieversorgungseinheit 42 wird unter Bezug auf Fig. 3 detaillierter dargestellt und beschrieben.

Die Auswerteeinheit 4 umfasst zudem die in Fig.1 bereits erwähnte Umwandlungseinheit 41, einen Mikrokontroller 49 mit (angeschlossener) ausgebildeter Kontaktlos-Datenschnittstelle 43 und Antenne 44. Zudem weist die Auswerteeinheit 4 eine Signalisierungseinheit 45, eine kontaktbehaftete Datenschnittstelle 46 und eine weitere Energieversorgungscinhcit 42a und eine SPI- Datenschnittstelle 47 auf, welche durch die Versorgungsspannung der Energieversorgungseinheit 42 betreibbar sind.

Die Umwandlungseinheit 41 ist beispielsweise ein Signalprozessor für Messapplikationen und ist mit dem ersten Anschlusskontakt 3a und dem zweiten Anschlusskontakt 3b des Stromsensors 3 verbunden, um den vom Stromsensor detektierten Stromwert aufzubereiten und mittels Delta-Sigma Wandlung zu digitalisieren.

Zudem empfängt die Umwandlungseinheit 41 das Potential des Außenleiters L und das Potenzial des Neutralleiters N, um den so detektierten Spannungswert aufzubereiten und mittels Delta-Sigma Wandlung zu digitalisieren.

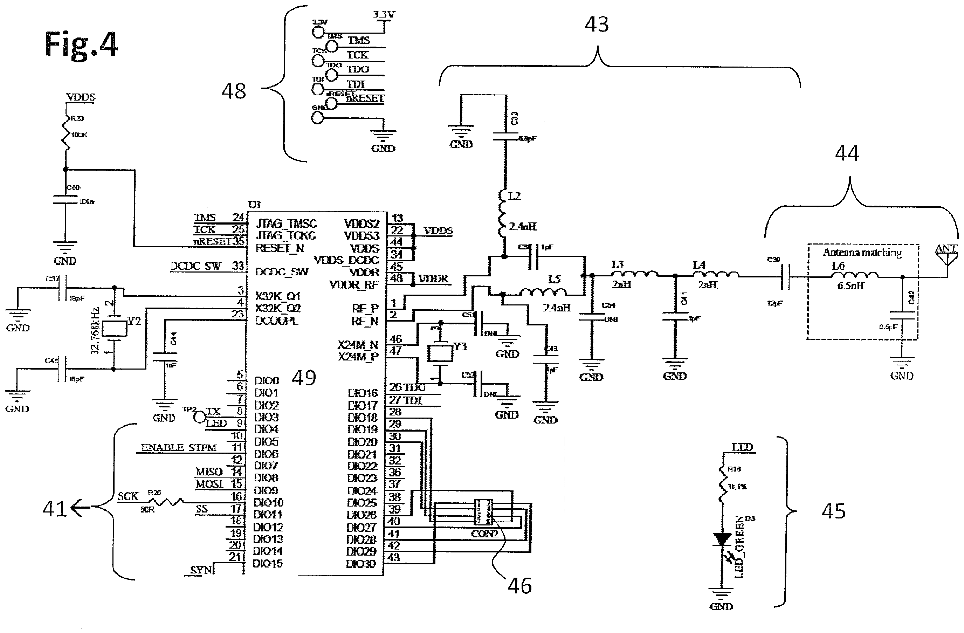

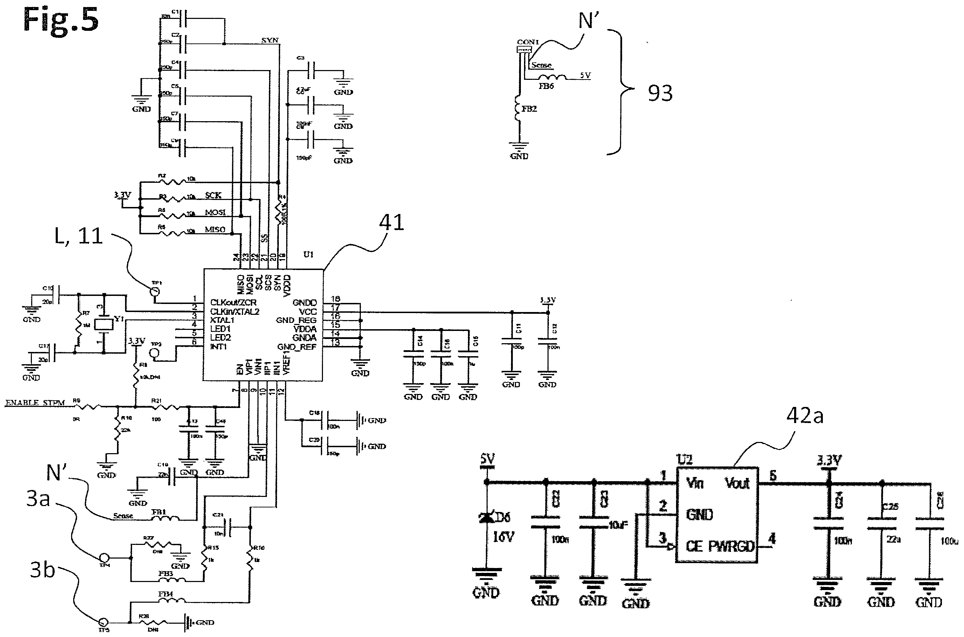

Ausgangsseitig stellt die Umwandlungseinheit 41 digitale Messwerte zur Verfügung, die über eine SPI-Datenschnittstelle an einen Mikrokontroller 49 und dann über die Kontaktlos-Datenschnittstelle 43 und die Antenne 44 weitergegeben werden, um an die externe Einheit 5 (Fig.1) ausgegeben zu werden. An die SPI-Datenschnittstelle 47 können weitere SPI-Geräte angeschlossen werden. Die Umwandlungseinheit 41 ist in Fig.5 näher beschrieben. Der Mikrokontroller mit daran angeschlossener Kontaktlos-Datenschnittstelle 43 und Antenne 44 ist in Fig.4 näher beschrieben.

Der Mikrokontroller 49 hat einen Speicher, in dem Berechnungsroutinen zum Auswerten der aufbereiteten Messwerte abgelegt sind. Diese Routinen können aktualisiert werden, beispielsweise über die Programmierschnittstelle JTAG.

Die Signalisierungseinheit 45 umfasst eine Leuchtdiode, um Statusinformationen der Kontaktlos-Datenschnittstelle anzuzeigen. Diese Informationen werden dem Benutzer beim Betrachten der Messvorrichtung A durch die Signalisierungseinheit 45 visualisiert, beispielsweise kann ein Fehlerfall, ein Überstromfall, ein Kurzschlussfall angezeigt werden.

Zudem ist eine optionale kontaktbehaftete Datenschnittstelle 46 vorbereitet, über die Status-Informationen eines Schutzschalters (nicht dargestellt) empfangen und gesendet werden können. Diese Informationen betreffen insbesondere den Status eines Schaltschlosses, einen Status und die Präsenz eines Unterbrecher- und Auslöseeinsatzes und eine Schaltstellung einer Kontakteinrichtung. Diese Status-Informationen können ebenfalls über die LED signalisiert werden.

Die Auswerteeinheit 4 der Fig.2 wird bevorzugt auf zwei getrennten Leiterplatinen 91, 92 angeordnet, was durch gestrichelte Linien dargestellt ist. Diese Leiterplatinen 91, 92 sind mittels Verbindungselementen 93 elektrisch verbunden. Die erste Leiterplatine 91 beinhaltet die Spannungsversorgungseinheit 42. Die zweite Leiterplatine 92 beinhaltet die Umwandlungseinheit 41, den Mikrokontroller 49, die Kontaktlos-Datenschnittstelle 43 mit der Antenne 44, die Signalisierungseinheit 45, die kontaktbehaftete Datenschnittstelle 46, die weitere Energieversorgungseinheit 42a und die SPI- Datenschnittstelle 47. Somit ist die zweite Leiterplatine 92, der eigentliche Kern der Auswerteeinheit und enthält den einphasigen Mess-IC (Einheit 41), den Mikrokontroller 49 für Berechnungsroutinen aus den erfassten Messwerten, die drahtlose Datenschnittstelle 43 mit Antenne 44 und weitere wesentliche Teile für den Betrieb, beispielsweise einen Quarz.

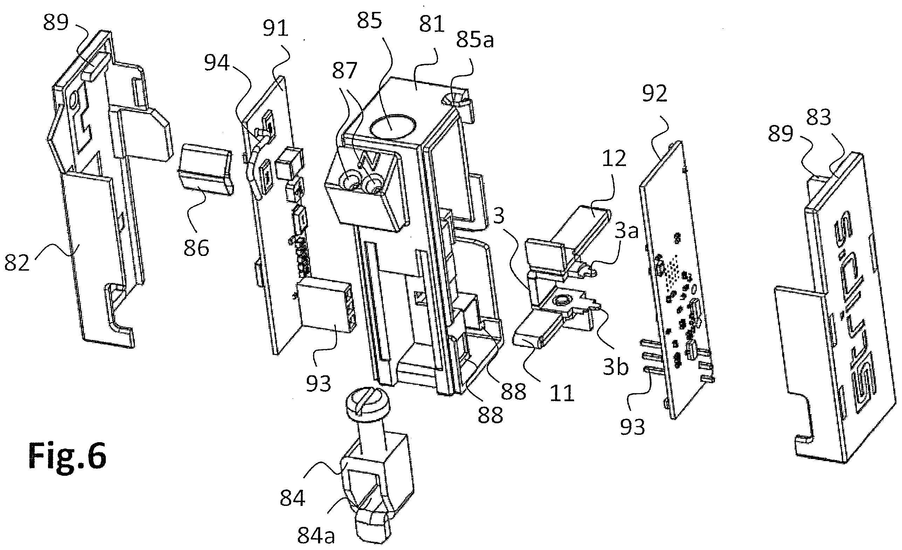

Das Anordnen der Leiterplatinen 91, 92 in der Messvorrichtung A wird in Fig.6 f. näher dargestellt.

Fig.3 ist ein detaillierteres Schaltbild einer Energieversorgungseinheit 42 der Fig.2 der Mehrfachmessvorrichtung A. Wie erwähnt, erhält die Energieversorgungseinheit 42 die beiden Potentiale L, N, um daraus eine stabilisierte Versorgungsspannung, hier 12 Volt Gleichspannung, zu gewinnen. Die gezeigte Elektronik der Fig.3 ist für sehr hohe Ströme ausgelegt. Das erhaltene L-Potential wird als Bezugspotenzial GND definiert. Damit wird die die erzeugte Gleichspannung auf das L-Potential bezogen. Diese Konfiguration funktioniert sowohl für Wechselgrößen als auch für Gleichgrößen am Eingang der Einheit 42, so dass sie für viele verschiedene Anwendung geeignet ist.

Das N-Potential wird über einen Spannungsteiler bestehend aus R1, R5, R6 und R7 über das Verbindungselement 93 an die Umwandlungseinheit (nicht dargestellt) bereitgestellt. Zudem erfolgt eine Spannungsglättung und -stabilisierung mittels Kondensatoren C4 und C. Der nachfolgende IC-Baustein U1, stellt durch die Spule L1, die Diode 2 und den Kondensator C1 als Abwärtswandler, auch Tiefsetzsteller, Abwärtsregler, englisch: "Step-Down Converter" oder auch "Buck Converter", einen schaltenden hocheffizienten Gleichspannungswandler dar. Eine galvanische Entkopplung mittels Bauteil U2 befreit die Spannung vom Erdpotential und eine weitere Glättung mittels Kondensatoren C2 und C6 erzeugt eine hochstabile Gleichspannung am Verbindungselement 93.

In Fig.4 ist ein detaillierteres Schaltbild des Mikrokontrollers 49 mit Kontaktlos-Datenschnittstelle 43 und Antenne 44, die Signalisierungseinheit 45, die SPI- Datenschnittstelle 42 zur Umwandlungseinheit 41 und eine Programmierschnittstelle 48 (JTAG) der Mehrfachmessvorrichtung A der Fig. 2 näher dargestellt.

Der Mikrokontroller mit der Kontaktlos-Datenschnittstelle 43 und Antenne 44 ist hier als ein Bluetooth 5.0 Sende- und Empfangsmodul ausgebildet und soll lediglich beispielhaft für eine breitbandige Funkverbindung zu einer externen Einheit 5 zum Ausgeben der Messwerte stehen. Der Mikrokontroller 49, beispielsweise ein CC2640-Baustein, empfängt eingangsseitig die aufbereiteten und digitalisierten Messwerte der Umwandlungseinheit 41 (angedeutet über die geschweifte Klammer 41). Die Kommunikation zwischen der Umwandlungseinheit 41 und dem Mikrokontroller 49 erfolgt kontaktbehaftet, beispielsweise über das Serial-Peripheral-Interface, SPI, protokollbasiert, also mittels eines Bus-Systems für einen synchronen seriellen Datenbus mit dem die digitalen Einheiten 41 und 49 nach dem Master-Slave-Prinzip miteinander aufbereitete, digitale Messwerte austauschen. Der Mikrokontroller 49 ist dabei der Master und generiert auch ein Signal zum Bereitmachen (Enable) an die Einheit 41. Eine Programmierschnittstelle JTAG 48 ist zu Aktualisierungszwecken vorgesehen. Ausgangsseitig wird am Mikrokontroller 49 eine Antennen-Anpassschaltung und eine Antenne 44 geschaltet, um die Messwerte mittels Bluetooth 5.0 an die externe Einheit (nicht dargestellt) zu übertragen.

Zudem ist eine kontaktbehaftete Datenschnittstelle 46 am Mikrokontroller 49 vorgesehen, mit der die bereits erwähnten Status-Informationen von/an einen Schutzschalter (nicht dargestellt) übertragen werden. Die an der kontaktbehafteten Datenschnittstelle 46 Daten werden auch an die externe Einheit weitergegeben. Zudem kann die externe Einheit auch Anfragen der externen Einheit an den Schutzschalter weitergeben.

In Fig.5 ist ein detaillierteres Schaltbild einer Umwandlungseinheit 41, einer weiteren Energieversorgungseinheit 42a und eines Verbindungselements 93 der Mehrfachmessvorrichtung A gemäß dem Blockschaltbild der Fig.2 näher dargestellt. Wie bereits mit Fig.2 beschrieben, empfängt diese Einheit 41 einen detektierten Stromwert über die Anschlusskontakte 3a, 3b des Stromsensors 3. Zudem empfängt diese Einheit 41 einen detektierten Spannungswert über die Verbindung zum L-Potential und zum N-Potential, dargestellt als N` vom Verbindungselement 93. Diese detektierten Werte werden in der Einheit 41 aufbereitet, digitalisiert und über die SPI- Datenschnittstelle von dem Mikrokontroller 49 abgefragt.

Eine weitere Spannungsversorgungseinheit 42a ist vorgesehen, um die von der Einheit 42 bereitgestellte Spannung weiter zu stabilisieren, beispielsweise mittels eines Bausteins MCP1755T.

Die Elektronik der Mehrfachmessvorrichtung A gemäß der Figuren 1 bis 5 kann dabei in unterschiedlichen Varianten eingesetzt werden und ist für eine Vielzahl von Anwendungen anwendbar.

In einer ersten Variante wird die Messvorrichtung A als zusätzliches Modul in einer einphasigen Hochstrom-Anwendung verwendet. Dabei kann eine drahtlose Messung am Verbraucher oder direkt an der Leitung erfolgen. Der Strommessbereich ist dabei von 0 Ampere bis 1600 Ampere, der Spannungsmessbereich ist von 0 Volt bis 500 Volt Effektivwert, RMS, zwischen dem Außenleiter L und dem Neutralleiter N. Alle Strommessbereiche werden mit der gleichen Elektronik erreicht und betragen; 0 bis 125A; 0 bis 160A; 0 bis 250A; 0 bis 400A; 0 bis 630A; 0 bis 1250A und 0 bis 1600A.

Dabei wird eine Messgenauigkeit (Nach DIN EN 60051) für Stromwerte mit der Genauigkeitsklasse 0,5, bei den Spannungswerten und Leistungswerten wird die Genauigkeitsklasse 1 erreicht. Eine Bemessungsisolationsspannung beträgt 1000 Volt bei einem Verschmutzungsgrad von 3, eine Bemessungsstoßspannung beträgt 8kV mit einem Überspannungsfaktor 3.

Eine Daten-Kommunikation zwischen der Auswerteeinheit 4 und der externen Einheit 5 erfolgt über Bluetooth 5.0, wobei auch Ferneinstellung und Steuerungen möglich sind. Dabei wird eine eindeutige Kennung (ID) übertragen, um eine schnelle und einfache Identifizierung und Bereitstellung zu ermöglichen. Die Signalisierungseinheit 45 ermöglicht eine visuelle Anzeige hinsichtlich Versorgungsspannungsstatus, Fehlerstatus, Übertemperatur, Sicherungszustand. Zudem ist eine Alarmierung bei detektierten Fehlerstrom oder Überstrom oder Kurzschluss vorgesehen.

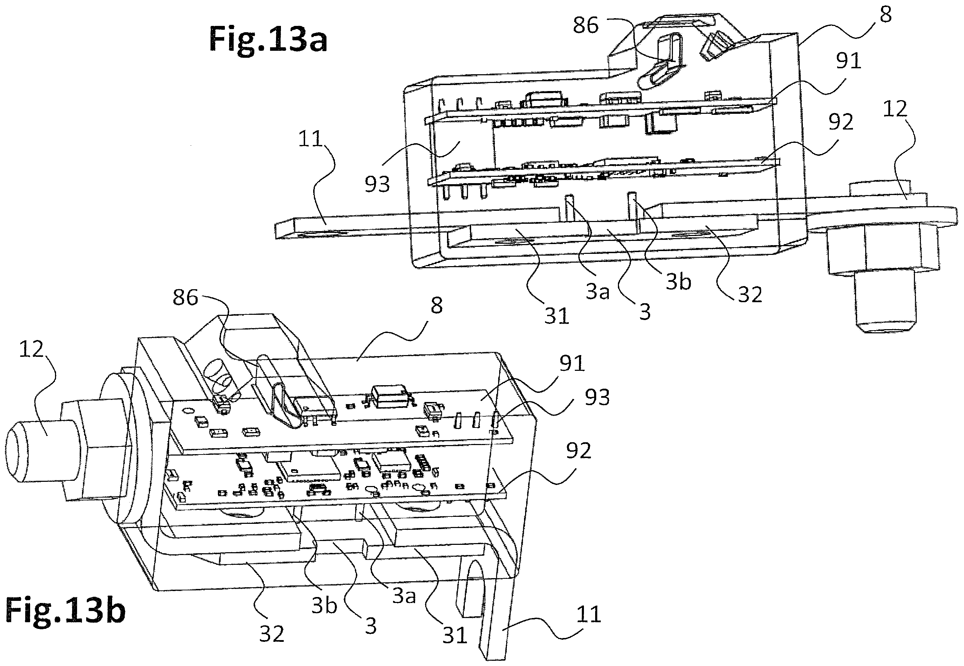

Ein Beispiel für die erste Variante des Einsatzes der Mehrfachmessvorrichtung A ist in den Fig.13a bis 13b beschrieben.

In einer zweiten Variante wird die Mehrfachmessvorrichtung A in einem Schutzgerät für eine Phase integriert. Das Schutzgerät kann z.B. ein Hybridgerät sein, dass die Funktionalität eines Leitungsschutzschalters (MCCB) und klassischer Schmelzsicherung vereint. Die Elektronik gemäß der Fig.1 bis 5 hat in der zweiten Variante die gleichen Parameter wie in der ersten Variante. Zusätzlich ist in einem derartigen Schutzgerät auch eine Funktion als Bimetall-Emulator (durch Abbilden einer Bi-Metall-Kurve in der Einheit 41) gegeben, sodass der Bimetall-Baustein ersetzt und die Kosten reduziert werden können. Die Elektronik der Fig.1 bis 5 übernimmt die Funktion des Bimetall-Moduls und schaltet das Gerät mittels Spule und Magnetauslöser ab, wenn der Strom I zwischen 1,45^{∗}I nominal und 10^{∗}I nominal in einer vordefinierten Zeitscheibe ist. In der zweiten Variante ist eine kontaktbehafte Datenschnittstelle 46 vorgesehen, um mit dem Schutzgerät weitere Informationen zu erhalten und mit der externen Einheit zu teilen, insbesondere der Status der Sicherungseinsätze, der Schaltzustand des Schutzschalters, Unterspannungsauslösung, periodische Selbstkontrolle der Elektronik, Auslösung bei festgestellter Fehlfunktion, das Verhindern des Einschaltens bei fehlender oder defekter Sicherung durch sowohl einen mechanischen also auch einen elektronischen Schutz. Die Elektronik löst den Magneten aus, wenn die Spannungsversorgung vorhanden ist. Der Status des Sicherungseinsatzes meldet einen Fehler oder einen Ausfall der Elektronik.

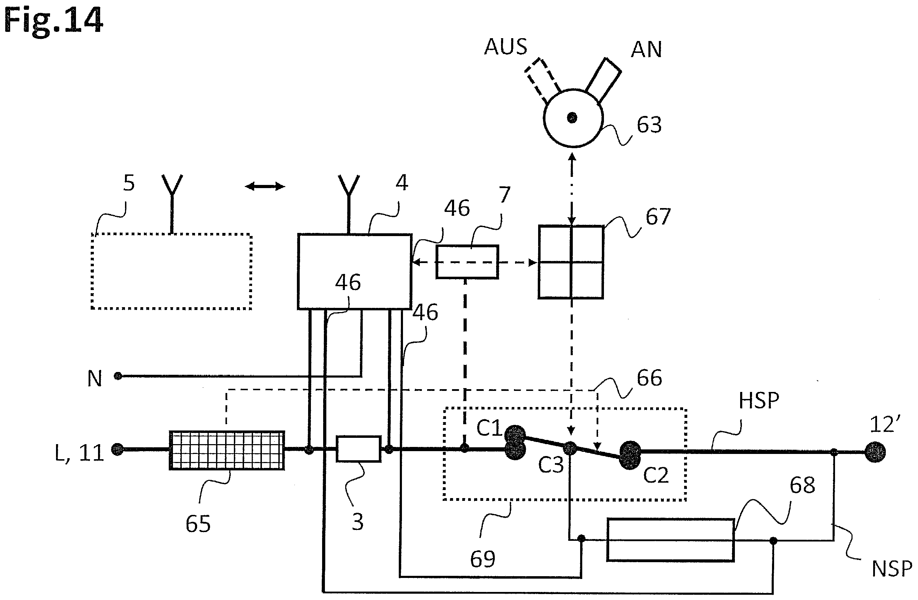

Die detaillierte Funktion für die zweite Variante des Einsatzes der Mehrfachmessvorrichtung A ist in den Fig.14 bis 16 beschrieben.

Eine dritte Variante des Einsatzes der Mehrfachmessvorrichtung ist der integrierte Einsatz in einem dreiphasigen Schutzgerät. Im baulichen Unterschied zur zweiten Variante, wird anstelle des Shunt-Widerstands als Stromsensor 3 eine Rogowski-Spule verwendet und eine Temperaturmessung erfolgt auf der Leiterplatte.

Die Elektronik in diesem Schutzgerät bildet die Funktion eines 3-Phasen-Multimeters ab und ermöglicht - ähnlich wie die zweite Variante - das elektronische Abbilden einer Bi-Metall-Kurve, um das Bi-Metall pro Phase ersetzen zu können. Die erhaltenen Messwerte gleichen denen der vorherigen Varianten, sind nun aber für alle 3-Phasen möglich. Somit sind auch vollständige 3-Phasen Stromzähler möglich. Die Spannungs- und Stromoberschwingungen (THD) können bis zur 32. Oberschwingung ermittelt und ausgewertet werden. Der Spannungsmessbereich erweitert sich auf Spannung von 0 bis 690V RMS (von L zu L anstelle L zu N), wobei die Messgenauigkeitsklassen gleich der der ersten und zweiten Variante bleibt.

In einer vierten Variante erfolgt eine modulare Vorschaltung eines Mehrfachmessvorrichtung A vor einen Schutzschalter, so, wie es in den Fig. 6 bis 12 dargestellt ist.

In Fig.6 ist eine dreidimensionale perspektivische Darstellung einer zerlegten Mehrfachmessvorrichtung A gemäß der vierten Variante der vorliegenden Erfindung dargestellt. Die Mehrfachmessvorrichtung A ist dabei in einem Gehäuse 8 eingebracht. Dabei wird die Auswerteeinheit auf zwei Leiterplatinen 91, 92, bevorzugt gleich groß ausgestaltet, angeordnet, so wie es in Fig.2 bereits beschrieben wurde. Auf der Leiterplatine 91 ist die Energieversorgungseinheit 42 und das Verbindungselement (3-Pin-Konnektor) 93 angeordnet. Auf der Leiterplatine 92 sind die übrigen Einheiten 41, 43 bis 48 angeordnet (siehe Fig.2 für Details). Das Verbindungselement 93 definiert einen Abstand zwischen den beiden Leiterplatinen 91, 92, um unerwünschte Einflüsse zu vermeiden.

Das Gehäuse 8 ist in der Fig.6 in einzelnen Teilen dargestellt. Das Gehäuse hat einen Mittelteil 81, eine erste Seitenabdeckung 82 und eine zweite Seitenabdeckung 83. Die Seitenabdeckungen 82, 83 weisen Erhöhungen 89 auf, mit denen die jeweiligen Leiterplatinen 91, 92 im Mittelteil 81 fixiert werden. Das Mittelteil 81 weist wiederum Abstufungen 88 innerhalb von beidseitigen Ausnehmungen (Kavitäten) auf, um die jeweilige Leiterplatte 91, 92 aufzunehmen. In eine der Ausnehmungen wird der Stromsensor 3 angeordnet, sodass dieser zwischen den beiden Leiterplatten 91, 92 angeordnet ist. Dies ermöglicht ein kompaktes Design der Mehrfachmessvorrichtung A. In dem Mittelteil 84 ist zudem ein Loch an einer Oberseite vorgesehen, unter dem passgenau eine LED auf der zweiten Leiterplatine 92 angeordnet ist. Diese LED ist Teil der Signalisierungseinheit 45 und ermöglicht ein visuelles Feedback bezüglich Übertragungsstatus oder Fehlerstatus.

Die Leiterplatte 91 umfasst zudem einen Neutralleiter-Anschluss 94 zu einer Klemmhalterung 86. Die Klemmhalterung 86 sitzt unter einem Doppelloch 87 für die Aufnahme des Neutralleiters N. Dies ermöglicht ein einfaches Kontaktieren des Neutralleiters N (nicht dargestellt) mit der Leiterplatine 91.

Eine Schraubenhalterung 84 ist im Mittelteil 81 des Gehäuses angeordnet. In einer Aufnahme 84a kann ein Außenleiter L (nicht dargestellt) aufgenommen und mittels der Schraubhalterung 84 mechanisch und elektrisch lösbar verbunden werden. Zum Aktivieren der Schraubhalterung 84 ist ein Loch 85 in dem Mittelteil 81 des Gehäuses 8 vorgesehen. Damit kann der Außenleiter L mit dem Eingangskontakt 11 des Stromsensors 3 elektrisch verbunden werden. Der Ausgangskontakt 12 des Stromsensors 3 ragt aus dem Gehäuse 8 heraus, um mit einem Eingangskontakt eines Schutzschalters (nicht dargestellt in Fig.6) einfach kontaktiert zu werden.

Die Anschlusskontakte 3a, 3b des Stromsensors 3 kontaktieren Leiterbahnen auf der zweiten Leiterplatine 92, um den detektierten Stromwert an die Umwandlungseinheit 41 bereitzustellen.

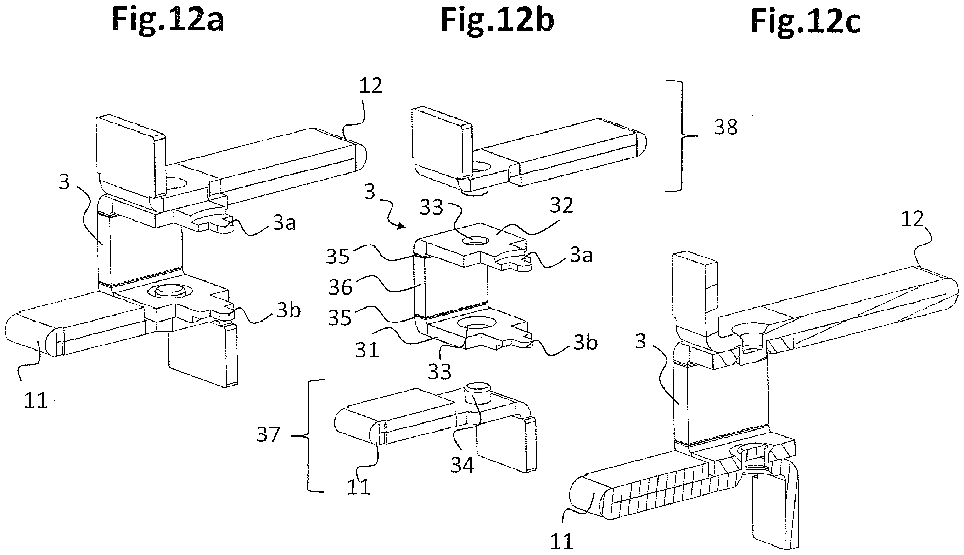

Der Fig.6 ist zu entnehmen, dass durch eine spezielle Formgebung des Stromsensors 3 ein äußerst kompaktes Design des Gehäuses und somit der Messvorrichtung A erzielt ist. Das beanstandete Anordnen der Leiterplatinen 91, 92 ermöglicht die Verringerung von Störeinflüssen der einzelnen Untereinheiten der Auswerte-Einheit 4 untereinander und entkoppelt zudem einen Hochspannungseingangsbereich von einem Niederspannungsbearbeitungsbereich. Der Stromsensor 3 ist in Fig.12a bis Fig.12c einzeln dargestellt und wird dort genau beschrieben.

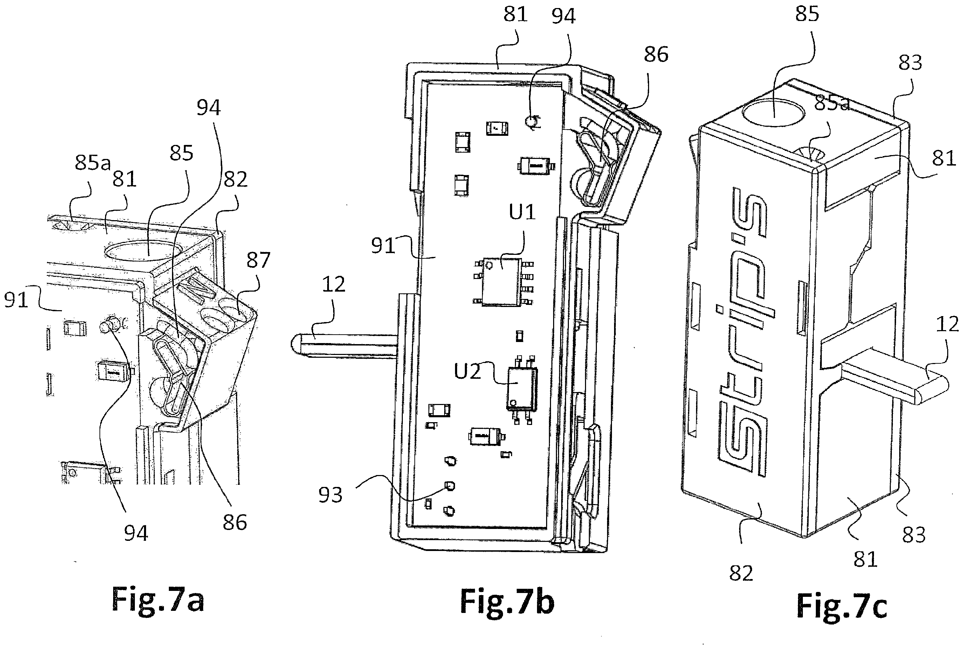

In Fig.7a bis 7c sind verschiedene dreidimensionale perspektivische Darstellung der Mehrfachmessvorrichtung gemäß Fig.6 dargestellt. Auf wiederholende Aussagen wird verzichtet und auch auf die Fig.6 verwiesen. Die Fig.7a zeigt das Gehäuse 8 mit Mittelteil 81 und erster Seitenabdeckung 82 teilweise. Die zweite Seitenabdeckung 82 (nicht dargestellt) wurde entfernt, sodass die erste Leiterplatine 91 zu erkennen ist. Die zweite Seitenabdeckung 82 dient demnach dazu, einen Teil der Auswerteeinheit 4 abzudecken und so vor Umwelteinflüssen und Berührungen stromführender Teile zu schützen. In Fig.7a ist die Klemmhalterung 86 für den Neutralleiter N (nicht dargestellt) im Detail zu erkennen. Sie besteht aus einem Federelement, um den Neutralleiter N einzuklemmen. Eine Anschlussleitung als Verbindung 94 von der Klemmhalterung 86 zur Leiterplatine 91 ist ebenfalls angedeutet. Der Neutralleiter N wird durch ein Loch 87 in dem Mittelteil 81 der Klemmhalterung 86 zugeführt.

Die Fig.7b zeigt das Gehäuse 8 mit Mittelteil 81 und erster Seitenabdeckung 82 vollständig. Dabei ist das Herausragen des Ausgangskontakts 12 zu erkennen, wodurch ein einfaches Kontaktieren eines nachfolgenden Schutzschalters (nicht dargestellt) ermöglicht ist.

Die Fig.7c zeigt die Messvorrichtung A im zusammengebauten Zustand mit Mittelteil 81, den Seitenabdeckungen 82, 83. Die Maße der Messvorrichtung A sind dabei an einen Schutzschalter angepasst. Dabei ist eine Grenzfläche, insbesondere die Frontfläche des Schutzschalters, zwischen Schutzschalter und Messvorrichtung nicht überschritten.

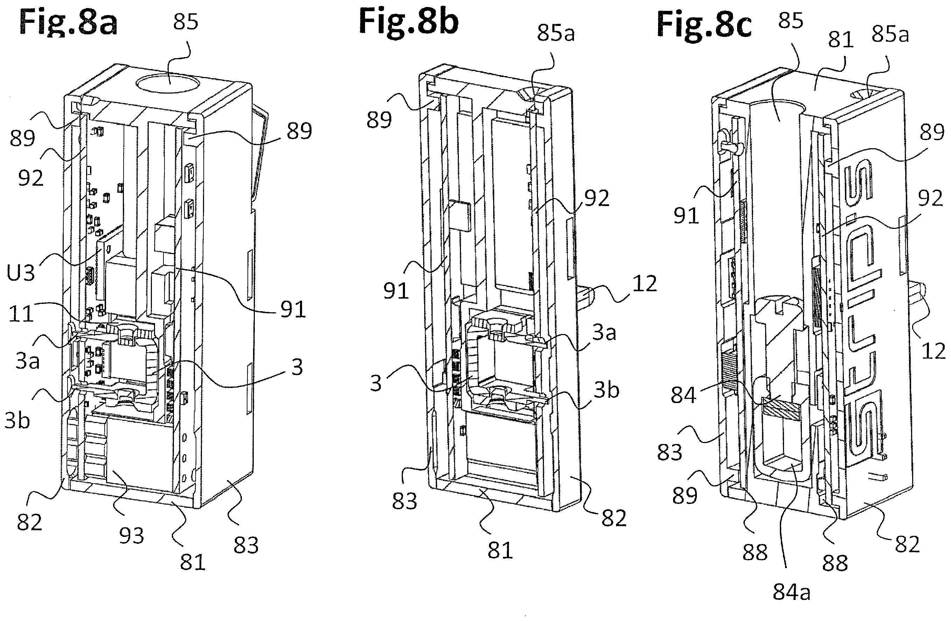

In Fig.8a bis 8c sind verschiedene dreidimensionale perspektivische Schnittdarstellungen der Mehrfachmessvorrichtung gemäß Fig.6 und Fig.7a bis 7c dargestellt, wobei nun die Messvorrichtung A zusammengebaut ist.

In Fig. 8a ist ein Querschnitt mittig durch das Mittelteil 81, orthogonal zu den Seitenabdeckungen 82, 83 dargestellt. Hier ist der Abstand zwischen den Leiterplatinen 91, 92 durch die Abmaße des Verbindungselements 93 definiert. Zwischen beiden Leiterplatinen 91, 92 ist der Stromsensor 3 platzsparend angeordnet. Die Anschlusskontakte 3a, 3b sind mit der Leiterplatine 92 verbunden und ragen durch diese hindurch. In der ersten Seitenabdeckung 82 sind Löcher eingebracht an den Stellen, an denen die Anschlusskontakte 3a, 3b die Leiterplatine 92 durchragen. Dies ermöglicht die Überprüfung der Funktionsfähigkeit des Stromsensors 3. Zudem ist der IC-Baustein U3 angedeutet (siehe Fig.2 und Fig.4). Die Erhöhung 89 an der ersten Seitenabdeckung 82 verursacht eine Fixierung der zweiten Leiterplatine 92 an dem Mittelteil 81 im zusammengebauten Zustand. Teilweise ist der Stromsensor 3 zu erkennen, der zwischen der ersten Leiterplatine 91 und der zweiten Leiterplatine 92 im Mittelteil 81 eingebracht ist.

In Fig.8b ist eine weitere Querschnittsabbildung durch das Mittelteil 81, orthogonal zu den Seitenabdeckungen 82, 83 dargestellt, wobei die Querschnittsline ca. bei zwei Drittel des Mittelteils 81 angeordnet ist. Hier ist eine Erhöhung 89 der zweiten Seitenabdeckung 83 gezeigt, die verursacht, dass im zusammengebauten Zustand die erste Leiterplatine 91 am Mittelteil 81 fixiert ist.

In Fig.8c ist eine weitere Querschnittsabbildung durch das Mittelteil 81, orthogonal zu den Seitenabdeckungen 82, 83 dargestellt, wobei die Querschnittsline ca. bei einem Drittel des Mittelteils 81 angeordnet ist. Im Vergleich zu Fig.8a und 8b ist die Messvorrichtung A um eine vertikale Achse um 180 Grad gedreht worden. Hier ist die Schraubenhalterung 84 mit der Aufnahme 84a und der Schacht zum Betätigen der Schraubenhalterung, zugänglich durch das Loch 85, im Querschnitt gezeigt. Zudem sind Abstufungen 88 am Mittelteil 81 dargestellt, die jeweils die Leiterplatinen 91, 92 aufnehmen können.

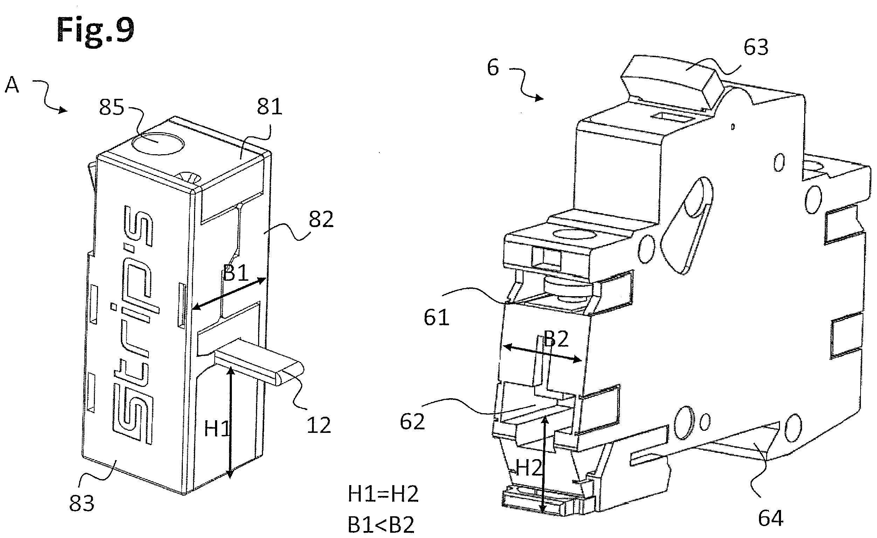

In Fig. 9 ist eine dreidimensionale perspektivische Darstellung eines Ausführungsbeispiels eines Systems aus dem erfindungsgemäßen Mehrfachmessvorrichtung gemäß Fig.1 und einem Schutzschalter 6 im getrennten Zustand dargestellt.

Die Darstellung der Messvorrichtung A ist identisch mit der Darstellung aus Fig.7c und es wird auf weitere Ausführungen verzichtet. Der Schutzschalter 6 ist ein Leitungsschutzschalter mit einem manuellen Schalter 63, einer Aufnahme 62 für einen Außenleiter L (nicht dargestellt) und einer Schraubhalterung 61 zum mechanisch lösbaren befestigen eines Außenleiters L. Eine Arretierung 64 ist dargestellt, welche den Schutzschalter 6 in einem Stromkasten einer Hausinstallation arretiert. Der Schutzschalter ist für diese Ausgestaltung ein nach VDE 0641-11 (EN-60898) standardisierter Schutzschalter, dessen Bauform und Abmaße festgelegt sind.

Eine Breite B1 der Messvorrichtung A einer dem Schutzschalter 6 zugewandten Oberseite ist nicht größer, bevorzugt sogar kleiner als die Breite B2 einer Frontseite des Schutzschalters.

Eine Höhe H1 des Außenkontakts 12 bezogen auf eine Grundseite der Messvorrichtung A ist identisch zu einer Höhe H2 der Aufnahme 62 des Schutzschalters 6 bezogen auf die Grundseite des Schutzschalters 6.

Diese Festlegung von B1 und H1 in Abstimmung mit den standardisierten Maßen für B2 und H2 ermöglicht eine platzsparende Unterbringung der Messvorrichtung A in einem Stromverteilkasten einer Hausverteilung.

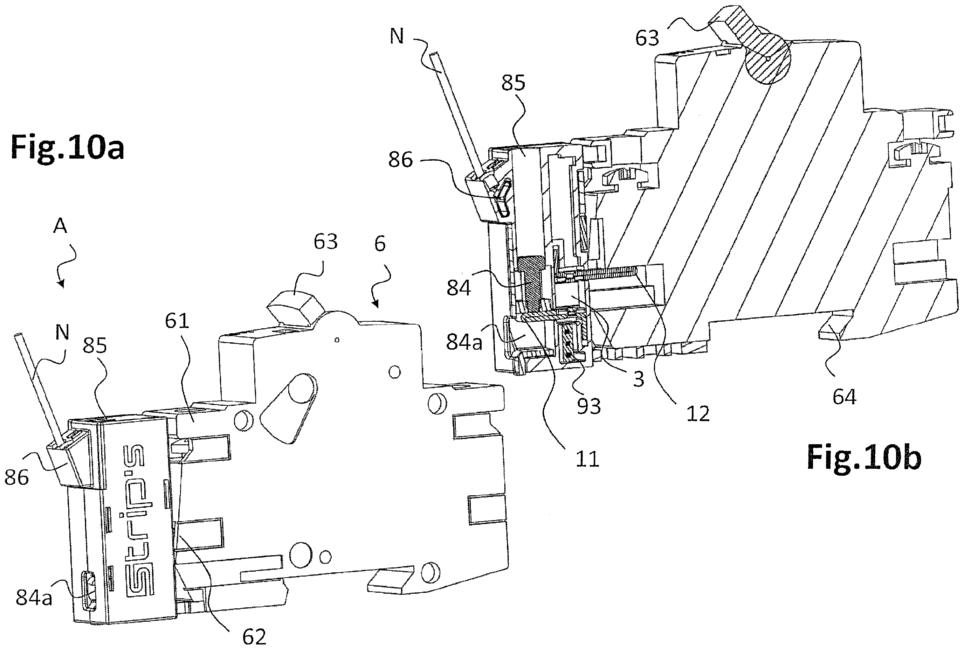

In Fig. 10a ist eine dreidimensionale perspektivische Darstellung des Ausführungsbeispiels eines Systems gemäß Fig.9 im verbundenen Zustand gezeigt. Zusätzlich ist ein Neutralleiter N in der Klemmhalterung 86 eingebracht.

Die Schraubhalterung 61 des Schutzschalters wird dazu verwendet, um den Ausgangskontakt 12 der Messvorrichtung A in der Aufnahme 62 des Schutzschalters für einen Außenleiter mechanisch und elektrisch zu verbinden. Aufgrund der massiven Ausgestaltung des Ausgangskontakts 12 und des geringen Eigengewichts der Messvorrichtung A sind keine zusätzlichen Befestigungsmaßnahmen zum Halten der Messvorrichtung A an dem Schutzschalter 6 notwendig. In die Aufnahme 84a der Messvorrichtung A kann nun ein Außenleiter L kontaktiert werden mittels Schraubhalterung 85, sodass der Außenleiter L mit der Messvorrichtung A und dem nachfolgenden Schutzschalter 6 elektrisch leitend und mechanisch lösbar verbunden ist.

In Fig. 10b ist eine dreidimensionale perspektivische Schnittdarstellung des Ausführungsbeispiels eines Systems gemäß Fig.9 und Fig.10a im verbundenen Zustand dargestellt. Hier ist deutlich die Kontaktierung des Ausgangskontakts 12 in der Aufnahme 62 zu erkennen. Zudem ist die aktivierte Klemmhalterung 86 zum Halten des Neutralleiters N gezeigt. Auch ist die aktivierbare Schraubhalterung 84 der Messvorrichtung A gezeigt, wobei zu Erläuterungen auf die vorherigen Figuren 6 bis 10a verwiesen wird.

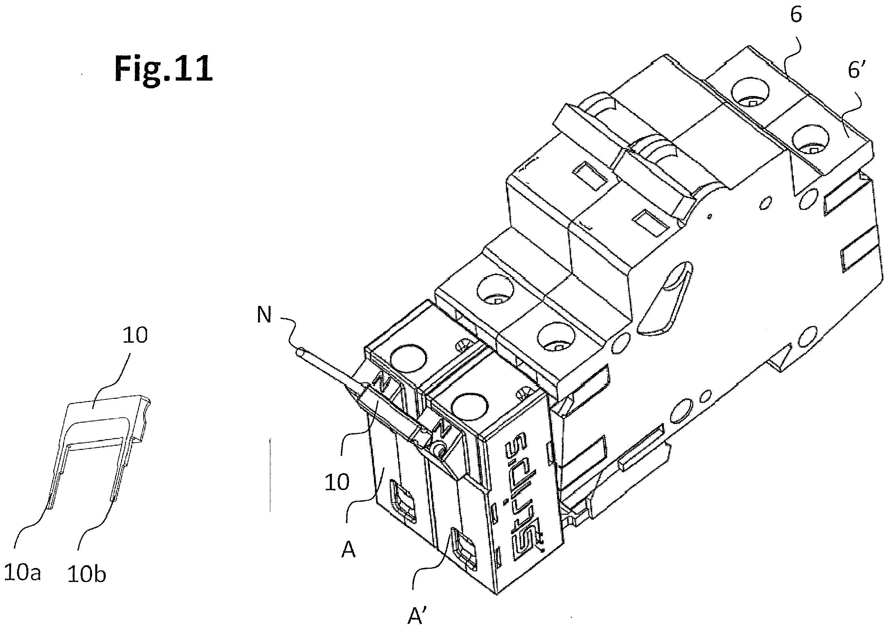

In Fig. 11 ist nun eine dreidimensionale perspektivische Darstellung eines Verbunds aus zwei Systemen gemäß dem Ausführungsbeispiel gemäß Fig.9 und Fig.10a im verbundenen Zustand mit Neutralleiterbrücke 10 gezeigt. Die Neutralleiterbrücke weist zwei Kontaktstiftc 10a, 10b auf, die in die jeweils innenliegenden Löcher 87 der Klemmhalterung 86 bei zwei benachbarten Messvorrichtungen A, A' gesteckt werden, um eine elektrische Brücke zwischen dem Neutralleiter-Anschluss der Messvorrichtung A und der benachbarten Messvorrichtung A' vereinfacht herzustellen. Auf diese Weise ist ein Verdrahten einer jeden Messvorrichtung A, A' mit einem eigenen Neutralleiter N nicht notwendig und so ist Platz im Stromverteilerkasten gespart.

Um ein Platzieren mehrerer Messvorrichtungen A, A' bei benachbarten Schutzschaltern 6, 6' zu ermöglichen, muss die Breite B1 der Messvorrichtung A geringer sein als die Breite B2 des Schutzschalters an einer Frontseite.

In Fig. 12a bis 12c sind verschiedene dreidimensionale perspektivische Darstellungen eines Ausführungsbeispiels eines erfindungsgemäßen Stromsensors 3 für eine Mehrfachmessvorrichtung A gemäß der Fig. 1, 2, 6 bis 11 gezeigt.

In Fig.12a ist der Stromsensor 3 mit einem ersten Kontaktfahnenelement 37 und einem zweiten Kontaktfahnenelement 38 im zusammengebauten Zustand dargestellt. Das Zusammenbauen erfolgt mechanisch unlösbar, beispielsweise durch Verschweißen oder Vernieten. Zu erkennen ist, dass der Stromsensor 3 trotz seiner hohen Stromfestigkeit im Kilo-Ampere-Bereich sehr kompakt ausgestaltet ist und somit die Messvorrichtung A sehr platzsparend aufgebaut werden kann. Diese Kompaktheit wird durch mehrfaches Abwinkeln sowohl der Anschlusselemente 31, 32 als auch der Anschlusskontakte 3a, 3b, wie in Fig.12b besser dargestellt ist.

In Fig.12b ist der Stromsensor 3 der Fig.12a aufgeteilt dargestellt. Das erste Kontaktfahnenelement 37 besteht aus Kupfer und ist mehrfach gebogen. Ein Abwinkeln des Kontaktfahnenelement 37 ermöglicht es, dass ein Halteteil dieses Kontaktfahnenelement 37 im Mittelteil 81 des Gehäuses fixiert werden kann. Zudem ist das Kontaktfahnenelement 37 an dem Ort des Eingangskontakts 11 umgebogen, um so eine stabilere Form zu erhalten. Da die Schraubenhalterung 85 auf dieses Kontaktfahnenelement 37 am Ort des Eingangskontakts 11 wirkt, kann durch dieses Umbiegen eine Langlebigkeit des Stromsensors 3 ermöglicht werden. Die gleichen Aussagen können auch für das zweite Kontaktfahnenelement 38 getroffen werden, dessen abgewinkeltes Halteelement ebenfalls im Mittelteil 81 des Gehäuses 8 fixiert wird.

In vertikaler Ausrichtung wird nun zwischen das erste Kontaktfahnenelement 37 und das zweite Kontaktfahnenelement 38 der Stromsensor 3 platziert. Durch diese vertikale Anordnung wird bereits eine erhebliche Platzeinsparung als bei beispielsweise einer flächigen Ausrichtung erzielt. Der Stromsensor 3 ist nun speziell geformt. Er weist ein plattcnförmiges Widerstandselement 36 in seiner Mitte auf. Dieses Element 36 hat eine definierte Länge, eine definierte Breite und eine definierte Höhe, um einen voreingestellten sehr stabilen Widerstandswert zu definieren. Das Material ist bevorzugt Manganin, alternativ wäre auch Konstantan denkbar. An zwei gegenüberliegenden Seitenflächen des Elements 36 sind nun jeweils ein abgewinkeltes Anschlusselement 31, 32 angeordnet. Beide Anschlusselemente 31, 32 weisen an dem vom Widerstandselement 36 entfernten Ende einen Anschlusskontakt 3a, 3b auf, mit dem der Stromsensor 3 die Leiterplatine 92 elektrisch leitend kontaktiert. Die Anschlusskontakte 3a, 3b sind dabei bevorzugt stiftförmig ausgebildet und weisen eine abgeflachte Seite auf, die das Kontaktieren auf der Leiterplatine erleichtert. Das Abwinkeln der Anschlusselemente 31, 32 erfolgt derart, dass die Anschlusskontakte 3a, 3b in einer Ebene orthogonal zur flächigen Ausrichtung des Widerstandselements 36 angeordnet sind. Bevorzugt wird durch die Anschlusselemente 31,32 und dem dazwischen angeordneten Widerstandselement 36 ein u-förmiger Stromsensor 3 erhalten. Dies reduziert den Platzbedarf weiter und verringert die Dimension der Messvorrichtung A deutlich.

In Fig.12c ist ein Querschnitt durch den Stromsensor 3 und die angrenzenden Kontaktfahnenelemente 37, 38 gezeigt. Zu erkennen ist, dass ein Verbindungsbolzen 34 des ersten Kontaktfahnenelement 37 in eine entsprechende Ausnehmung 33 des Anschlusselements 31 passgenau eingesetzt ist. der Bolzen 34 wird dann entweder gestanzt, genietet oder verschweißt. Gleiches Verbindungsprinzip wird beim Kontaktfahnenelement 38 und der Verbindung zum zweiten Anschlusselement 32 angewendet.

In Fig.13a und 13b sind dreidimensionale perspektivische Darstellungen eines Ausführungsbeispiels einer Mehrfachmessvorrichtung A gemäß der ersten Variante der vorliegenden Erfindung gezeigt.

In Fig.13a ist eine Hochstrom-Version der Messvorrichtung A gezeigt. Wie oben erwähnt ist die Elektronikschaltung gemäß der Fig.1 bis 5 identisch für alle Ausführungsvarianten. Im Unterschied zu der vierten Variante ist hier ein flächiger Stromsensor 3 ausgebildet, dessen Anschlusselemente 31, 32 nicht gegenüber dem Widerstandselement abgewinkelt ist. Die Auswerteeinheit 4 ist wiederum auf zwei Leiterplatinen 91, 92 verteilt, die den oben beschriebenen Leiterplatinen 91, 92 gleichen. Eine Klemmhalterung 86 ist vorgesehen, um einen Neutralleiter N (nicht dargestellt) elektrisch und mechanisch zu kontaktieren. Ein Verbindungselement 93 beabstandet die beiden Leiterplatinen 91, 92. Der Eingangskontakt 11 und der Ausgangskontakt 12 sind massiv ausgestaltet und weisen Schraubverbindungen der Größenordnung M12 bis M16 auf. Die Messvorrichtung der Fig.13a stellt eine horizontalc Version dar, während die Messvorrichtung A der Fig.13b eine vertikale Version darstellt. In Fig.13b ist deshalb der Eingangskontakt 11 abgewinkelt.

In Fig. 14 ist ein Schaltbild eines Leitungsschutzschalters gemäß einem Ausführungsbeispiel der vorliegenden Erfindung gemäß der zweiten Variante im eingeschalteten Zustand im störungsfreien Betrieb dargestellt.

Dabei weist der Leitungsschutzschalter einen Magnetauslöser 66 mit einer Spule 65 und einem Anker auf, der über einen Schlagstift auf eine Kontakteinrichtung 69 einwirkt. Die Spule 65 ist mit einem Ende mit dem Eingangskontakt 11 eines Außenleiters L und mit ihrem anderen Ende mit einem gemeinsamen Schaltkontakt C1 verbunden. Der Stromsensor 3 ist in Reihe zwischen der Spule 65 und dem gemeinsamen Kontakt C1 angeordnet.

Der Leitungsschutzschalter der Fig.14 ist in einem störungsfreien Betrieb im eingeschalteten Zustand dargestellt. Im eingeschalteten Zustand ist der gemeinsame Schaltkontakt C1 über einen dritten Schaltkontakt C3 hinweg mit einem anderen Schaltkontakt C2 verbunden. Der andere Schaltkontakt C2 ist über ein elektrisches Leitungselement, das einen Teil des Hauptstrompfads HSP bildet, mit einem Ausgangskontakt 12' des Leitungsschutzschalters verbunden. Ein Strompfad verbindet so den Eingangskontakt 11 mit dem Ausgangskontakt 12 des Leitungsschutzschalters über die Spule 65 und den Stromsensor 3. Im störungsfreien Normalbetrieb werden die Kontakte 11, 12 ausschließlich durch die Reihenschaltung von der Spule 65, dem Stromsensor 3, dem gemeinsamen Schaltkontakt C1, dem anderen Schaltkontakt C2 und dem elektrischen Leitungselement des Hauptstrompfads HSP verbunden. Der Stromsensor 3 kann alternativ auch zwischen Eingangskontakt 11 und der Spule 65 angeordnet werden.

Parallel zum Hauptstrompfad HSP ist ein Nebenstrompfad NSP zwischen einem dritten Kontakt C3 und dem Ausgangskontakt 12' geschaltet. Der dritte Schaltkontakt C3 ist elektrisch mit einem Unterbrecher- und Auslöseeinsatz 68 in Reihe geschaltet. Der Unterbrecher- und Auslöse-einsatz 68 ist auswechselbar zwischen zwei Klemmkontakte eingesetzt, von denen der erste Klemmkontakt über ein Leitungselement mit dem dritten Schaltkontakt C3 und der zweite Klemmkontakt über ein weiteres Leitungselement mit dem Ausgangskontakt 12' verbunden ist. Es ist möglich, dass der Stromsensor 3 in den Nebenstrompfad NSP anstelle des Hauptstrompfads HSP (nicht dargestellt in Fig.14) in Reihe zum Unterbrecher- und Auslösesatz 68 angeordnet ist. Dies erhöht die Energieeffizienz, wenn beispielsweise ein sensibler Magnetauslöser 66 verwendet wird, der bei jeglichem Strom oberhalb eines Nennstrom, also sowohl im Störungsfall als auch im Kurzschlussfall, den anderen Schaltkontakt C2 öffnet, um den Strom in den Nebenstrompfad NSP umzuleiten.

Es ist auch möglich, dass in dem Nebenstrompfad NSP ein thermischer Auslöser (nicht dargestellt in Fig.14) in Reihe zum Unterbrecher- und Auslöseeinsatz 68 angeordnet ist. Eine Reihenfolge bei der Anordnung von Unterbrecher- und Auslöseeinsatz 68 zu thermischem Auslöser und Stromsensor 3 ist je nach den Einbaubedingungen im Leitungsschutzschalter zu wählen, so dass der Unterbrecher- und Auslöseeinsatz 68 auch unmittelbar mit dem dritten Schaltkontakt C3 verbunden ist, während der thermischen Auslöser zwischen dem Unterbrecher- und Auslöseeinsatz 68 und dem Anschlusskontakt 12' angeordnet sein kann.

Der Unterbrecher- und Auslöseeinsatz 68 kann einen Schlagstift aufweisen, mit dem er auf ein Schaltschloss 67 einwirkt. Ein Bimetall-Element des thermischen Auslösers kann gegebenenfalls auf das Schaltschloss 67 einwirken (nicht dargestellt).

Der thermische Auslöser kann erfindungsgemäß (so wie auch in Fig.14 gezeigt) weggelassen werden. Eine Wirkungskurve des thermischen Auslösers wird in der Auswerteeinheit 4 hinterlegt. Ein Temperatursensor auf einer der Leiterplatinen 91, 92 liefert einen Temperaturmesswert, der mit der abgespeicherten Kurve verglichen wird. Bei Überschreitung eines definierten Temperaturmesswertes veranlasst die Auswerteeinheit 4 das Auslösen des Auslösers 7.

Das Schaltschloss 67, das unten soweit erforderlich näher beschrieben wird, ist auch von einem manuellen Schalter 63 betätigbar und wirkt seinerseits auch auf den Schalter 63 ein, wie durch den gestrichelten Doppelpfeil gezeigt ist, um diesen in seine AUS-Stellung zu bewegen, wenn der Leitungsschutzschalter im Störungsfall den gestörten Bereich des Stromnetzes unterbricht. Der Störungsfall kann ein mittels Stromsensor 3 erfasster Überstroms oberhalb eines vordefinierten Vielfachen eines Nennstroms für eine gewisse Zeitspanne sein, wenn also der Leitungsschutzschalter aufgrund des Überstroms sowohl den Haupt- als auch den Nebenstrompfad HSP, NSP zwischen Eingangskontakt 11 und Ausgangskontakt 12' unterbricht. Es kann aber auch ein Kurzschluss auftreten, durch den der Leitungsschutzschalter zunächst den Hauptstrompfad HSP zwischen den Kontakten C3 und 12` unterbricht, um den Strom auf den Unterbrecher- und Auslösesatz 10 umzuleiten.

Gemäß Fig.14 fließt im störungsfreien Normalbetrieb des erfindungsgemäßen Leitungsschutzschalters der Strom vom Eingangskontakt 11 über die Spule 65 des Magnetauslösers 66 und den Stromsensor 3 zum gemeinsamen Schaltkontakt C1 und zum anderen Schaltkontakt C2 und über das elektrische Leitungselement des Hauptstrompfads HSP zum Ausgangskontakt 12`. Obwohl der gemeinsame Schaltkontakt C1 geschlossen ist, fließt über den Nebenstrompfad NSP mit dem Unterbrecher- und Auslöseeinsatz 68 praktisch kein Strom, da der Nebenstrompfad NSP durch den Hauptstrompfad HSP kurzgeschlossen ist.

Der Strom im Hauptstrompfad HSP wird durch den Stromsensor 3 erfasst. Die tatsächliche Position des Stromsensors 3 im elektrischen Schaltbild des Leitungsschutzschalters ist frei wählbar und kann an die baulichen Gegebenheiten des Leitungsschutzschalters angepasst werden. Der Stromsensor 3 sollte jedoch in der Nähe der Kontakteinrichtung 69 angeordnet sein, um einen verlässlichen aktuellen Stromwert zu erfassen, der tatsächlich über den Ausgangskontakt 12' zu einem Stromverbraucher fließt. Der Stromsensor 3 kann alternativ auch als Stromtransformator ausgebildet sein, sodass der erfasste Strom durch induktive Kopplung erhalten wird. Dies ermöglicht eine galvanische Trennung der Stromerfassung vom Netzstrom und vereinfacht möglicherweise den Verschaltungsaufwand einer an den Stromsensor 3 angeschlossenen Auswerteeinheit 4. Der Stromsensor 3 kann überdies auch eine Rogowski-Spule sein.

Der Stromsensor 3 erfasst permanent oder kontinuierlich in definierten Zeitabständen den Stromwert (Ist-Stromwert). Mit definierten Zeitabständen sind insbesondere äquidistante Zeitabstände von weniger als 1 Sekunde, bevorzugt weniger als 100 Millisekunde, mehr bevorzugt alle 10 Millisekunden, gemeint. Dabei ist die Auswerteeinheit 4 vorgesehen, in diesen definierten Zeitabständen, den erfassten Strom mit einem vordefinierten Referenzstromwert (Soll-Stromwert) zu vergleichen.

Dieser vordefinierte Referenzstromwert ist beispielsweise oberhalb eines Nennstromwertes, bevorzugt dem 1,1 bis 5-fachen des Nennstromwerts, mehr bevorzugt dem 1,2 bis 2-fachen des Nennstromwertes, noch mehr bevorzugt dem 1,45-fachen des Nennstromwerts. Ergibt ein Vergleich in der Auswerteeinheit 4, dass der mittels Stromsensors 3 erfasste Strom größer ist als der vordefinierte Referenzstromwert, also beispielsweise dem 1,45-fachen des Nennstromwerts, so wird eine Zeituhr gestartet. Der Vergleich wird zudem in den oben genannten äquidistanten Zeitabständen wiederholt.

Ergibt der Vergleich im Wiederholungsfall, dass der erfasste Stromwert unterhalb des Referenzstromwertes ist, so wird die Zeituhr gelöscht und kein Störungsfall erkannt.

Ergibt der Vergleich im Wiederholungs-Fall, dass der erfasste Stromwert weiterhin oberhalb des Referenzstromwertes ist, so wird die Zeituhr mit einer vordefinierten Zeitdauer verglichen. Ist die vordefinierte Zeitdauer noch nicht überschritten, wird der Vergleich gemäß den bereits erwähnten äquidistanten Zeitabständen erneut wiederholt. Ist die vordefinierte Zeitdauer bereits überschritten und war für jeden einzelnen Vergleich der vom Stromsensor 3 erfasste Stromwert oberhalb des Referenzstromwertes, so liegt ein Störungsfall vor. Sodann sendet die Auswerteeinheit 4 ein elektrisches Signal über die kontaktbehaftete Datenschnittstelle 46 an einen Auslöseschalter 7, auch als Trigger bezeichnet. Dieser Auslöseschalter 7 aktiviert das Schaltschloss 67 derart, dass zumindest der gemeinsame Schaltkontakt C1 der Kontakteinrichtung 69 geöffnet wird und somit der Hauptstrompfad HSP als auch der Nebenstrompfad NSP zeitgleich unterbrochen werden.

Ergibt der Vergleich in einem der erneuten Wiederholungsfälle, dass der erfasste Stromwert unterhalb des Referenzstromwertes ist, so wird die Zeituhr gelöscht und kein Störungsfall erkannt. Die äquidistanten Zeitabstände für die Stromwert-Erfassung können ab dem Erkennen eines erfassten Stromwertes oberhalb des Referenzstromwertes auch variiert werden, beispielsweise können diese Zeitabstände verkürzt werden.

Die Variationen der äquidistanten Zeitabstände und/oder auch die Länge der vordefinierten Zeitdauer können abhängig vom Vergleichsergebnis sein. Beispielsweise können bei einem erfassten Stromwert der weit größer ist als der Referenzstromwert - beispielsweise 20% größer als der Referenzstrom oder noch mehr - die äquidistanten Zeitabstände und/oder die vordefinierte Zeitdauer kürzer gewählt werden als bei einem erfassten Strom, der nur minimal größer ist als der Referenzstrom - beispielsweise weniger als 20% größer als der Referenzstrom.

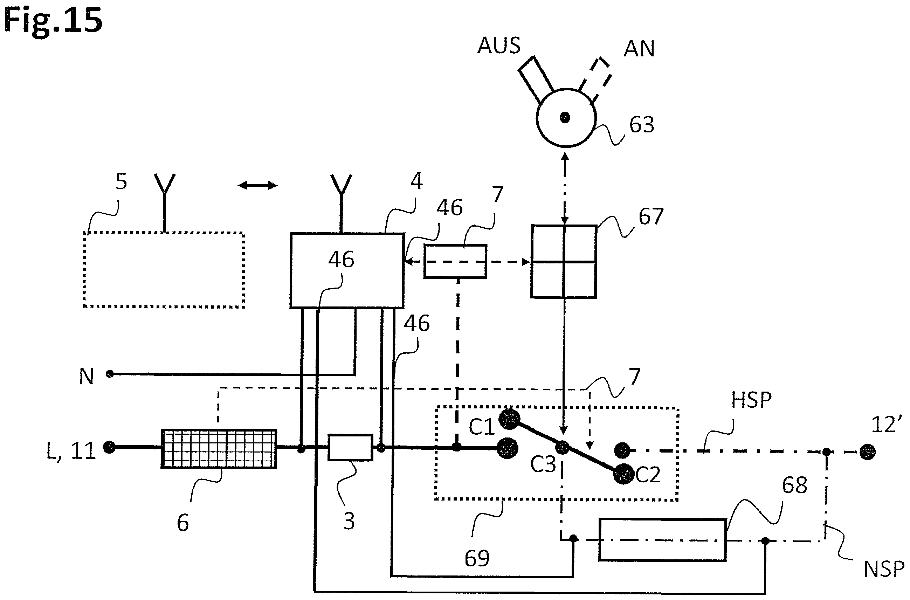

Gemäß Fig. 15 wird der Leitungsschutzschalter gemäß der zweiten Variante der vorliegenden Erfindung im ausgeschalteten Zustand beispielsweise nach Auftreten eines Störungsfalls dargestellt.

Tritt beispielsweise aufgrund einer Störung auf der Verbraucherseite des Stromnetzes oder auf der Erzeugerseite ein Überstrom, also ein Strom oberhalb des Referenzstromwertes, auf, so wird dies gemäß der oben dargestellten Überwachung mittels dem Stromsensor 3, der Auswerteeinheit 4 und dem Auslöser 7 erfasst. Wird dabei der oben beschriebene Störungsfall erkannt, so schaltet die Kontakteinrichtung 69 mittels des Schaltschlosses 67 derart, dass der gemeinsame Schaltkontakt C1 geöffnet wird. Dabei kann ggf. (so wie in Fig.15 dargestellt) gleichzeitig auch der anderen Schaltkontakt C2 geöffnet werden.

Wird nach der Behebung der Störung im Stromnetz der Schalter 63 manuell wieder in seine EIN-Stellung gebracht, so kann durch diese Bewegung auch eine Klinke des Schaltschlosses 67 aus der AUS-Stellung wieder in die EIN-Stellung bewegt werden. Die Veränderung im Schaltschloss 67 wird über die kontaktbehaftete Datenschnittstelle 46 an das IC-Bauteil U3 gemeldet (siehe Doppelpfeil in Fig.15 zwischen Schaltschloss 67 und Auswerteeinheit 4).

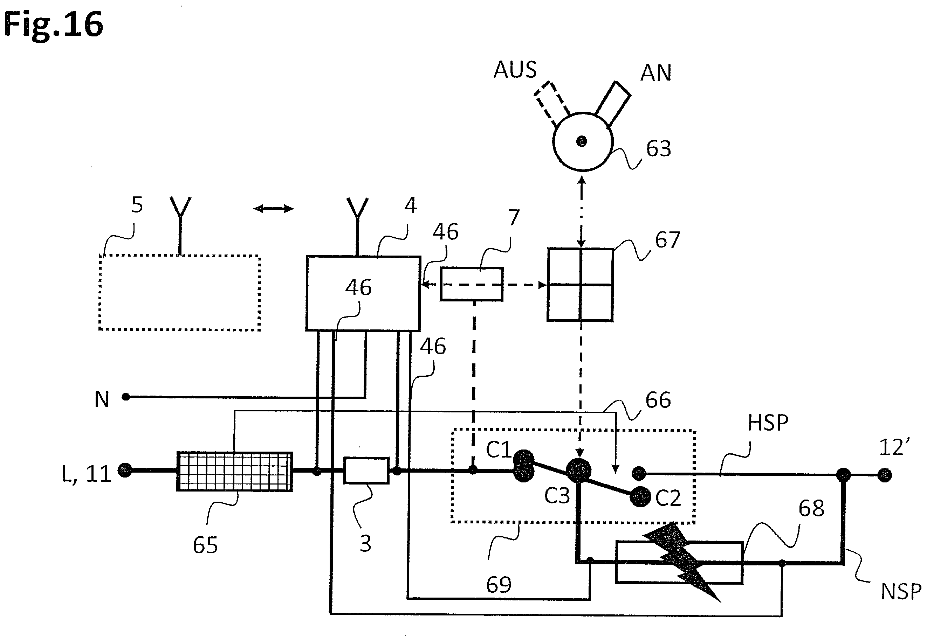

In Fig.16 ist der Leitungsschutzschalter im Kurzschlussfall dargestellt. Im Kurzschlussfall, der einen wesentlich größeren Stromwert als den Referenzstromwert zum Erkennen des Störungsfalls, also beispielsweise dem 5 bis 10-fachen des Nennstromwerts oder mehr, bevorzugt dem 2 bis 5-fachen des Nennstromwerts oder mehr, hervorruft, spricht zunächst der Magnetauslöser 66 an. Im Kurzschluss wird in der Spule 65 des Magnetauslösers 66 eine Magnetkraft erzeugt, mit der nur der andere Schaltkontakt C2 geöffnet wird. Dies unterbricht nur den Hauptstrompfad HSP. Eine Einklink-Vorrichtung an der Kontakteinrichtung 69 auf der Seite der Spule 65 des Magnetauslösers 7 kann dabei in Eingriff gebracht beziehungsweise gehalten werden, damit der andere Schaltkontakt C2 nicht von selbst wieder geschlossen werden kann. Zu beachten ist, dass zunächst der gemeinsame Schaltkontakt C1 geschlossen bleibt, so dass der Kurzschlussstrom über den Nebenstrompfad NSP umgeleitet wird. Nun spricht der Unterbrecher- und Auslöseeinsatz 68 an, der praktisch gleichzeitig den Nebenstrompfad NSP unterbricht. Dies ist durch den stilisierten Blitz in Fig.16 dargestellt. Es wird also der aufgrund der Unterbrechung des Hauptstrompfads HSP stromlose Kontakt C2 geöffnet, ohne dass es zu einem Lichtbogen kommen kann.

Besonders vorteilhaft ist es, wenn die Auswerteeinheit 4 das Unterbrechen des Nebenstrompfads NSP durch den Unterbrecher- und Auslöseeinsatz 68 elektronisch über die kontaktbehaftete Datenschnittstelle 46 erfasst, beispielsweise durch das Erfassen eines im Nebenstrompfad NSP durch das Unterbrechen generierten Spannungsabfall am Unterbrecher-und Auslöseeinsatz 68 in der Auswerteeinheit 4, wie durch die beiden Linien in Fig.16 vom Nebenstrompfad NSP zur Auswerteeinheit 4 dargestellt ist. Daraufhin aktiviert die Auswerteeinheit 4 den Auslöseschalter 7 elektronisch, um das Schaltschloss 67 auszulösen, wodurch dann der gemeinsame Schaltkontakt C1 geöffnet wird. Dies ist insbesondere vorteilhaft, wenn kein Schlagstift, englisch Striker-PIN, am Unterbrecher- und Auslösesatz 68 vorhanden ist, um das Schaltschloss 67 zu aktivieren.

Aufgrund der Umleitung des Stroms in den Nebenstrompfad NSP nach dem Unterbrechen des Hauptstrompfads 1 (gemäß Fig.16) fällt aufgrund der ohmschen Eigenschaften des Schmelzdrahtes am Unterbrecher- und Auslösesatz 68 eine geringe Spannung ab. Dieser geringe Spannungsabfall im Nebenstrompfad NSP wird durch die gezeigte elektrische Verbindung zwischen Nebenstrompfad NSP und Auswerteeinheit 4 sofort in der Auswerteeinheit 4 erfasst, sodass die Auswerteeinheit 4 erkennt, dass der Hauptstrompfad HSP unterbrochen ist. Somit kann sowohl ein Störungsfall bei bloßer Umleitung in den Nebenstrompfad NSP als auch ein Kurschlussfall in der Auswerteeinheit 4 prompt erfasst werden und das Schaltschloss 67 mittels Auslöseschalter 7 aktiviert werden. Im Kurzschlussfall muss das vollständige Unterbrechen des Nebenstrompfads NSP durch den Unterbrecher- und Auslösesatz 68 durch die Auswerteeinheit 4 abgewartet werden, um einen Kontaktabbrand am Schaltkontakt C1 bei vorzeitigem Öffnen im stromführenden Zustand zu vermeiden.

Im Kurzschlussfall unterbricht der Unterbrecher- und Auslösesatz 68 den Nebenstrompfad NSP, wobei dies in der Auswerteeinheit 4 durch einen großen Spannungsabfall über dem Unterbrecher- und Auslösesatz 68 erfasst wird. Das Unterbrechen des Nebenstrompfads NSP wird durch die Auswerteeinheit 4 elektronisch erfasst, woraufhin der Auslöseschalter 7 mittels Steuersignal von der Auswerteeinheit 4 betätigt wird, um das Schaltschloss 67 zu aktivieren und den gemeinsamen Schaltkontakt C1 zu öffnen. Dabei wird auch der manuelle Schalter 63 in seine AUS-Stellung gebracht, so wie es bereits mit Fig.15 beschrieben wurde. Im Kurzschlussfall muss das vollständige Unterbrechen des Nebenstrompfads NSP durch den Unterbrecher- und Auslösesatz 68 durch die Auswerteeinheit 4 abgewartet werden, um einen Kontaktabbrand am Schaltkontakt C1 bei vorzeitigem Öffnen im stromführenden Zustand zu vermeiden.

In einer (nicht näher dargestellten) Variante wird der Unterbrecher- und Auslöseeinsatz 68 von einem Schmelzeinsatz gebildet, dessen Schmelzdraht und/oder Haltedraht in nicht näher dargestellter Weise einen Kontaktstift gegen die Kraft einer (nicht dargestellten) Feder hält. Sobald der Schmelzdraht und gegebenenfalls der Haltedraht des Schmelzeinsatzes aufgrund eines hohen Kurzschlussstroms schmelzen, wird der Stift von der im Schmelzeinsatz vorgesehenen Feder schlagartig in seine Auslösestellung bewegt, wodurch er das Schaltschloss 67 wie oben beschrieben betätigt.

Nach dem Auslösen des der Unterbrecher- und Auslöseeinsatz 68 im Kurzschlussfall muss der Unterbrecher- und Auslöseeinsatz 68 ersetzt werden. Hierfür kann am Gehäuse des Leitungsschutzschalters eine abnehmbare Kappe oder dergleichen vorgesehen sein. Wird die Kappe, gegebenenfalls nach dem Lösen von geeigneten Befestigungsmitteln, abgenommen, so kann gleichzeitig der Unterbrecher- und Auslöseeinsatz 68 mit nach oben genommen und zwischen den Klemmenkontaktelementen herausgezogen werden. Der Unterbrecher- und Auslöseeinsatz 68 lässt sich somit ohne Werkzeug aus dem erfindungsgemäßen Leitungsschutzschalter entnehmen und durch einen neuen ersetzen. Es kann vorgesehen sein, dass ein Schalthebel im eingeschalteten Zustand mit seinem Betätigungsabschnitt die Kappe gegen ein Abnehmen sichert. Daher muss der Leitungsschutzschalter vor dem Auswechseln des Unterbrecher- und Auslöseeinsatzes 68 ausgeschaltet sein. Erfolgt dies jedoch nicht vorher, so wird der Leitungsschutzschalter zwangsweise ausgeschaltet, da nicht nur der Betätigungsabschnitt des Schalthebels des manuellen Schalters 63 die Abnahme der Kappe blockiert und somit bei der Abnahme der Kappe zwangsweise betätigt wird, sondern da auch der Hebel, der mit einem Stift des Unterbrecher- und Auslöseeinsatzes 68 zusammenwirkt, betätigt würde. Somit kann sichergestellt werden, dass der nach der Abnahme der Kappe geöffnete Bereich des Leitungsschutzschalters spannungsfrei geschaltet ist. Die den Unterbrecher- und Auslöseeinsatz 68 abdeckende Kappe ist also nur im ausgeschalteten Zustand des Leitungsschutzschalters abnehmbar.

### Bezugszeichenliste

- L: Außenleiter
11 Eingangskontakt
12, 12` Ausgangskontakt
- N: Neutralleiter
- 3: Stromsensor
3a, erster Anschlusskontakt
3b zweiter Anschlusskontakt
31 Anschlusselement
32 Anschlusselement
33 Loch für Verbindungsbolzen
34 Verbindungsbolzen
35 Schweißverbindung
36 Widerstandselement
37 erstes Kontaktfahnenelement
38 zweites Kontaktfahnenelement
- 4: Auswerteeinheit
41 Umwandlungseinheit
42,42a Energieversorgungseinheit
43 Kontaktlos-Datenschnittstelle
44 Antenne
45 Signalisierungseinheit
46 kontaktbehaftete Datenschnittstelle
47 SPI- Datenschnittstelle
48 Programmierschnittstelle JTAG
49 Mikrocontroller
- 5: Externe Einheit
- 6: Schutzschalter, CB
61 Schraubhalterung für Außenleiter
62 Eingangskontakt und Aufnahme für Außenleiter
63 manueller Schalter
64 Arretierung
65 Spule
66 Magnetauslöser
67 Schaltschloss
68 Unterbrecher- und Auslöseeinsatz
69 Kontakteinrichtung
C1 erste Kontaktstelle
C2 zweite Kontaktstelle
C3 dritte Kontaktstelle
HSP Hauptstrompfad
NSP Nebenstrompfad
- 7: Auslöseschalter
- 8: Gehäuse
81 Mittelteil
82 erste Seitenabdeckung
83 zweite Seitenabdeckung
84 Schraubhalterung für Außenleiter
84a Aufnahme für Außenleiter
85 Zugang zur Schraubhalterung
85a Loch für LED-Anzeige
86 Klemmhalterung für Neutralleiter
87 Loch für Neutralleiter-Anordnung
88 Abstufung
89 Erhöhung
- 9: Leiterplatine für Auswerteeinheit
91 erste Leiterplatine
92 zweite Leiterplatine
93 Verbindungselement
94 Neutralleiter-Anschluss
- 10: Neutralleiter-Brücke
10a erster Anschlussstift
10b zweiter Anschlussstift

## Patentansprüche

1. Mehrfachmessvorrichtung (A) zum Erfassen und Ausgeben mindestens eines Messwertes umfassend:
- einen Stromsensor (3) zum Detektieren eines Stromwerts angeordnet in Reihenschaltung zwischen einem Eingangskontakt (11) und einem Ausgangskontakt (12) eines Außenleiters (L);
- eine elektronische Auswerteeinheit (4), elektrisch verbunden mit:
- einem ersten Anschlusskontakt (3a) des Stromsensors (3), der mit dem Eingangskontakt (11) elektrisch verbunden ist;
- einem zweiten Anschlusskontakt (3b) des Stromsensors (3), der mit dem Ausgangskontakt (12) elektrisch verbunden ist; und
- einem Neutralleiter (N),
- wobei die Auswerteeinheit (4) eingerichtet ist zum:
- Umwandeln des detektierten Stromwertes in einen auswertbaren Messwert;
- Auswerten des auswertbaren Messwerts mittels einer Umwandlungseinheit (41); und
- Ausgeben des ausgewerteten Messwerts zumindest mittels einer Kontaktlos-Datenschnittstelle (43);
- wobei die Energie zum Betreiben der Auswerteeinheit (4) aus einer Spannungsdifferenz zwischen den Potenzialen des Außenleiters (L) und des Neutralleiters (N) in einer Energieversorgungseinheit (42, 42a) der Auswerteeinheit (4) erhalten ist.

2. Mehrfachmessvorrichtung (A) nach Anspruch 1, wobei der Stromsensor (3) umfasst:
- ein plattenförmiges Widerstandselement (36), bevorzugt aus Manganin; und
- ein erstes abgewinkeltes Anschlusselement (31), bevorzugt aus Kupfer, wobei ein erstes Ende des ersten abgewinkelten Anschlusselements (31) mit einer ersten Seite des Widerstandselements (36) verschweißt ist, und wobei an einem zweiten Ende des ersten abgewinkelten Anschlusselements (31) der erste Anschlusskontakt (3a) angeordnet ist, und wobei das erste Ende des ersten abgewinkelten Anschlusselements (31) vom zweiten Ende des ersten abgewinkelten Anschlusselements (31) entfernt ist.

3. Mehrfachmessvorrichtung (A) nach Anspruch 2, wobei der Stromsensor (3) zudem umfasst:
- ein zweites abgewinkeltes Anschlusselement (32), bevorzugt aus Kupfer, wobei ein erstes Ende des zweiten abgewinkelten Anschlusselements (32) mit einer, der ersten Seite gegenüberliegenden, zweiten Seite des Widerstandselements (36) verschweißt ist, wobei an einem zweiten Ende des zweiten abgewinkelten Anschlusselements (32) der zweite Anschlusskontakt (3b) angeordnet ist, und wobei das erste Ende des zweiten abgewinkelten Anschlusselements (32) vom zweiten Ende des zweiten abgewinkelten Anschlusselements (32) entfernt ist.

4. Mehrfachmessvorrichtung (A) nach Anspruch 3, wobei der Stromsensor (3) zudem umfasst:
- ein erstes Kontaktfahnenelement (37), bevorzugt aus Kupfer, aufweisend den Eingangskontakt (11) und mechanisch verbunden mit dem ersten abgewinkelten Anschlusselement (31); und
- ein zweites Kontaktfahnenelement (38), bevorzugt aus Kupfer, aufweisend den Ausgangskontakt (12) und mechanisch verbunden mit dem zweiten abgewinkelten Anschlusselement (32).

5. Mehrfachmessvorrichtung (A) nach einem der vorhergehenden Ansprüche, umfassend ein Gehäuse (8) aufweisend:
- ein Mittelteil (81) zum Aufnehmen der Auswerteeinheit (4) und des Stromsensors (3),
- eine erste Seitenabdeckung (82) zum Abdecken einer ersten Seite der Auswerteeinheit (4); und
- eine zweite Seitenabdeckung (83) zum Abdecken einer zweiten Seite der Auswerteeinheit (4).

6. Mehrfachmessvorrichtung (A) nach Anspruch 5, wobei:
- das Mittelteil (81) eine erste Leiterplatine (91) aufweisend die Energieversorgungseinheit (42) der Auswerteeinheit (4) aufnimmt,
- das Mittelteil eine zweite Leiterplatine (92) aufweisend die Umwandlungseinheit (41) der Auswerteeinheit (4) aufnimmt,
- zwischen der ersten Leiterplatine (91) und der zweiten Leiterplatine (92) der Stromsensor (3) im Mittelteil (81) angeordnet ist;
- wobei die erste Leiterplatine (91) und die zweite Leiterplatine (92) voneinander beabstandet sind, und
- wobei die erste Leiterplatine (91) mit der zweiten Leiterplatine (92) mit zumindest einem Verbindungselement (93) elektrisch verbunden ist.

7. Mehrfachmessvorrichtung (A) nach einem der vorhergehenden Ansprüche, aufweisend eine Schraubhalterung (84) zum lösbaren Verbinden des Außenleiters (L) am Eingangskontakt (11).

8. Mehrfachmessvorrichtung (A) nach einem der vorhergehenden Ansprüche, aufweisend eine Klemmhalterung (86) zum mechanisch lösbaren Kontaktieren des Neutralleiters (N) mit der Auswerteeinheit (4).

9. Mehrfachmessvorrichtung (A) nach einem der vorhergehenden Ansprüche, wobei der Ausgangskontakt (12) elektrisch mit einem Außenleiter-Eingangskontakt (62) eines Schutzschalters (6) verbindbar ist, wobei ein elektrisches Kontaktieren des Ausgangskontakts (12) mit dem Eingangskontakt (62) des Schutzschalters (6) bevorzugt mechanisch lösbar mittels einer Schraubhalterung (61) des Schutzschalters (6) erfolgt.

10. Mehrfachmessvorrichtung (A) nach Anspruch 9, wobei der elektrische Kontakt zum Neutralleiter (N) mittels einer Neutralleiter-Brücke (10) von einer ersten Mehrfachmessvorrichtung (A) zur benachbarten zweiten Mehrfachmessvorrichtung (A') erfolgt.

11. Schutzschalter (6), bevorzugt Leitungsschutzschalter, modular mit einer Mehrfachmessvorrichtung (A) gemäß einem der Ansprüche 1 bis 4 erweitert.

12. Schutzschalter nach Anspruch 11, wobei der Stromsensor (3) den Strom in einem Hauptstrompfad (HSP) permanent erfasst und wobei die Auswerte-Einheit (4) dazu vorgesehen ist, den detektierten Stromwert auszuwerten, um einen Störungsfall zu erkennen, wobei im Störungsfall der detektierte Stromwert oberhalb eines definierten Vielfachen eines Nennstroms für eine vordefinierte Zeitspanne liegt.

13. Schutzschalter nach Anspruch 12, wobei die Auswerte-Einheit (4) im detektierten Störungsfall einen Auslöseschalter (7) ansteuert, mit dessen Aktivierung ein Schaltschloss (67) zur Öffnung und Fixierung einer Kontakteinrichtung (69) des Schutzschalters auslöst.

14. Schutzschalter nach einem der Ansprüche 11 bis 13, wobei die Auswerte-Einheit (4) einen Status eines Schaltschlosses (67), einen Status eines Unterbrecher- und Auslöseeinsatzes (68) und eine Schaltstellung einer Kontakteinrichtung (69) erfasst und über die Kontaktlos-Datenschnittstelle ausgibt.

15. Schutzschalter (6) nach einem der Ansprüche 11 bis 14 weiterhin aufweisend:
zwei parallel geführten Strompfade, die als Haupt- und Nebenstrompfad (HSP, NSP) über eine Kontakteinrichtung (69) in Reihe zu einer Spule (65) eines Magnetauslösers (66) geschaltet sind,
wobei im Störungsfall ein Schaltschloss (67) zur Öffnung und Fixierung der Kontakteinrichtung (69) auslöst, um einen gemeinsamen Schaltkontakt (C1) der Kontakteinrichtung (69) zu öffnen, um den Haupt- und den Nebenstrompfad (HSP, NSP) zu unterbrechen,
wobei der Magnetauslöser (66) im Kurzschlussfall einen anderen Schaltkontakt (C2) der Kontakteinrichtung (69) öffnet, um ausschließlich den Hauptstrompfad (HSP) zu unterbrechen,
wobei im Nebenstrompfad (NSP) ein Unterbrecher- und Auslöseeinsatz (68) angeordnet ist, der im Kurzschlussfall den Nebenstrompfad (NSP) unterbricht und das Schaltschloss (67) zur Öffnung und Fixierung der Kontakteinrichtung (69) auslöst, um den gemeinsamen Schaltkontakt (C1) für den Haupt- und den Nebenstrompfad (HSP, NSP) zu unterbrechen,
wobei der Stromsensor (3) in Reihe zu der Spule (65) und der Kontakteinrichtung (69) geschaltet ist.

## Claims

1. A multimeter (A) for detecting and outputting at least one measured value, comprising:
- a current sensor (3) for detecting a current value, arranged in series connection between an input contact (11) and an output contact (12) of an external conductor (L);
- an electronic evaluation unit (4), electrically connected to:
- a first connection contact (3a) of the current sensor (3), which is electrically connected to the input contact (11);
- a second connection contact (3b) of the current sensor (3), which is electrically connected to the output contact (12); and
- a neutral conductor (N),
- wherein the evaluation unit (4) is arranged for:
- converting the detected current value into an evaluatable measured value;
- evaluating the evaluatable measured value by means of a conversion unit (41); and
- outputting the evaluated measured value at least by means of a contactless data interface (43);
- wherein the energy for operating the evaluation unit (4) is obtained from a voltage difference between the potentials of the external conductor (L) and the neutral conductor (N) in an energy supply unit (42, 42a) of the evaluation unit (4).

2. The multimeter (A) according to claim 1, wherein the current sensor (3) comprises:
- a plate-shaped resistance element (36), preferably made of manganin; and
- a first angled connection element (31), preferably made of copper, wherein a first end of the first angled connection element (31) is welded to a first side of the resistance element (36), and wherein the first connection contact (3a) is arranged at a second end of the first angled connection element (31), and wherein the first end of the first angled connection element (31) is remote from the second end of the first angled connection element (31).

3. The multimeter (A) according to claim 2, wherein the current sensor (3) further comprises:
- a second angled connection element (32), preferably made of copper, wherein a first end of the second angled connection element (32) is welded to a second side of the resistance element (36) opposite to the first side, wherein the second connection contact (3b) is arranged at a second end of the second angled connection element (32), and wherein the first end of the second angled connection element (32) is remote from the second end of the second angled connection element (32).

4. The multimeter (A) according to claim 3, wherein the current sensor (3) further comprises:
- a first contact lug element (37), preferably made of copper, having the input contact (11) and being mechanically connected to the first angled connection element (31); and
- a second contact lug element (38), preferably made of copper, having the output contact (12) and being mechanically connected to the second angled connection element (32).

5. The multimeter (A) according to any one of the preceding claims, comprising a housing (8), having:
- a central part (81) for accommodating the evaluation unit (4) and the current sensor (3),
- a first side cover (82) for covering a first side of the evaluation unit (4); and
- a second side cover (83) for covering a second side of the evaluation unit (4).

6. The multimeter (A) according to claim 5, wherein:
- the central part (81) accommodates a first printed circuit board (91) having the energy supply unit (42) of the evaluation unit (4),
- the central part accommodates a second printed circuit board (92) having the conversion unit (41) of the evaluation unit (4),
- the current sensor (3) is arranged in the central part (81) between the first printed circuit board (91) and the second printed circuit board (92);
- wherein the first printed circuit board (91) and the second printed circuit board (92) are spaced apart from each other, and
- wherein the first printed circuit board (91) is electrically connected to the second printed circuit board (92) by means of at least one connecting element (93).

7. The multimeter (A) according to any one of the preceding claims, having a screw holder (84) for detachably connecting the external conductor (L) to the input contact (11).

8. The multimeter (A) according to any one of the preceding claims, having a clamp holder (86) for mechanically detachable contacting the neutral conductor (N) with the evaluation unit (4).

9. The multimeter (A) according to any one of the preceding claims, wherein the output contact (12) is electrically connectable to an input contact (62) of an external conductor of a circuit breaker (6), wherein electrical contacting of the output contact (12) with the input contact (62) of the circuit breaker (6) is preferably done in a mechanically detachable manner by means of a screw holder (61) of the circuit breaker (6).

10. The multimeter (A) according to claim 9, wherein the electrical contact to the neutral conductor (N) is done by means of a bridge (10) of the neutral conductor from a first multimeter (A) to an adjacent second multimeter (A').

11. A circuit breaker (6), preferably a line circuit breaker, modularly expanded with a multimeter (A) according to any one of claims 1 to 4.

12. The circuit breaker according to claim 11, wherein the current sensor (3) permanently detects the current in a main current path (HSP) and wherein the evaluation unit (4) is provided for evaluating the detected current value in order to recognise a malfunction, wherein, in the case of a malfunction, the detected current value is above a defined multiple of a nominal current for a predefined period of time.

13. The circuit breaker according to claim 12, wherein the evaluation unit (4) controls a trigger switch (7) when a malfunction is detected, the activation of which triggers a switch latch (67) for opening and fixing a contact device (69) of the circuit breaker.

14. The circuit breaker according to any one of claims 11 to 13, wherein the evaluation unit (4) detects a status of a switch latch (67), a status of an interrupter and trigger insert (68) and a switching position of a contact device (69) and outputs it via the contactless data interface.

15. The circuit breaker according to any one of claims 11 to 14, further having:
two current paths routed in parallel, which are connected in series to a coil (65) of a magnetic release (66) as main and secondary current paths (HSP, NSP) via a contact device (69),
wherein, in the case of a malfunction, a switch latch (67) is triggered for opening and fixing a contact device (69) in order to open a common switching contact (C1) of the contact device (69) in order to interrupt the main and secondary current paths (HSP, NSP),
wherein the magnetic release (66) opens another switching contact (C2) of the contact device (69) in the case of a short circuit in order to only interrupt the main current path (HSP),
wherein an interrupter and trigger insert (68) is arranged in the secondary current path (NSP), which in the case of a short circuit interrupts the secondary current path (NSP) and triggers the switch latch (67) for opening and fixing a contact device (69) in order to interrupt the common switching contact (C1) for the main and secondary current paths (HSP, NSP),
wherein the current sensor (3) is connected in series to the coil (65) and the contact device (69).

## Revendications

1. Dispositif de mesure multiple (A) pour détecter et générer au moins une valeur mesurée, comprenant :
- un capteur de courant (3) pour détecter une valeur de courant agencé en série entre un contact d'entrée (11) et un contact de sortie (12) d'un conducteur extérieur (L) ;
- une unité d'évaluation électronique (4), électriquement reliée à :
- un premier contact de raccordement (3a) du capteur de courant (3) électriquement relié au contact d'entrée (11) ;
- un second contact de raccordement (3b) du capteur de courant (3) électriquement relié au contact de sortie (12) ; et
- un conducteur neutre (N),
- dans lequel l'unité d'évaluation (4) est configurée pour :
- convertir la valeur de courant détectée en une valeur mesurée évaluable ;
- évaluer la valeur mesurée évaluable au moyen d'une unité de conversion (41) ; et
- générer la valeur mesurée évaluée au moins au moyen d'une interface de données sans contact (43) ;
- dans lequel l'énergie pour faire fonctionner l'unité d'évaluation (4) est obtenue à partir d'une différence de tension entre le potentiel du conducteur extérieur (L) et le conducteur neutre (N), dans une unité d'alimentation en énergie (42, 42a) de l'unité d'évaluation (4).

2. Dispositif de mesure multiple (A) selon la revendication 1, dans lequel le capteur de courant (3) comprend :
- un élément de résistance en forme de plaque (36), de préférence en manganin ; et
- un premier élément de raccordement coudé (31), de préférence en cuivre, dans lequel une première extrémité du premier élément de raccordement coudé (31) est soudée à un premier côté de l'élément de résistance (36), et dans lequel le premier contact de raccordement (3a) est agencé à une seconde extrémité du premier élément de raccordement coudé (31), et dans lequel la première extrémité du premier élément de raccordement coudé (31) est distante de la seconde extrémité du premier élément de raccordement coudé (31).

3. Dispositif de mesure multiple (A) selon la revendication 2, dans lequel le capteur de courant (3) comprend en outre :
- un second élément de raccordement coudé (32), de préférence en cuivre, dans lequel une première extrémité du second élément de raccordement coudé (32) est soudée à un second côté de l'élément de résistance (36) opposé au premier côté, dans lequel le second contact de raccordement (3b) est agencé à une seconde extrémité du second élément de raccordement coudé (32), et dans lequel la première extrémité du second élément de raccordement coudé (32) est distante de la seconde extrémité du second élément de raccordement coudé (32).

4. Dispositif de mesure multiple (A) selon la revendication 3, dans lequel le capteur de courant (3) comprend en outre :
- un premier élément de languette de contact (37), de préférence en cuivre, comportant le contact d'entrée (11) et mécaniquement assemblé avec le premier élément de raccordement coudé (31) ; et
- un second élément de languette de contact (38), de préférence en cuivre, comportant le contact de sortie (12) et mécaniquement assemblé avec le second élément de raccordement coudé (32).

5. Dispositif de mesure multiple (A) selon l'une des revendications précédentes, comprenant un boîtier (8) comportant :
- une partie centrale (81) pour recevoir l'unité d'évaluation (4) et le capteur de courant (3),
- un premier couvercle latéral (82) pour recouvrir un premier côté de l'unité d'évaluation (4) ; et
- un second couvercle latéral (83) pour recouvrir un second côté de l'unité d'évaluation (4).

6. Dispositif de mesure multiple (A) selon la revendication 5, dans lequel :
- la partie centrale (81) reçoit une première carte à circuit imprimé (91) comportant l'unité d'alimentation en énergie (42) de l'unité d'évaluation (4),
- la partie centrale reçoit une seconde carte à circuit imprimé (92) comportant l'unité de conversion (41) de l'unité d'évaluation (4),
- le capteur de courant (3) est agencé dans la partie centrale (81) entre la première carte à circuit imprimé (91) et la seconde carte à circuit imprimé (92) ;
- dans lequel la première carte à circuit imprimé (91) et la seconde carte à circuit imprimé (92) sont espacées l'une de l'autre, et
- dans lequel la première carte à circuit imprimé (91) est électriquement reliée à la seconde carte à circuit imprimé (92) par au moins un élément de connexion (93).

7. Dispositif de mesure multiple (A) selon l'une des revendications précédentes, comportant une fixation par vis (84) pour raccorder le conducteur extérieur (L) au contact d'entrée (11) de manière amovible.

8. Dispositif de mesure multiple (A) selon l'une des revendications précédentes, comportant une fixation à serrage (86) pour mettre mécaniquement en contact le conducteur neutre (N) avec l'unité d'évaluation (4) de manière amovible.

9. Dispositif de mesure multiple (A) selon l'une des revendications précédentes, dans lequel le contact de sortie (12) peut être électriquement relié à un contact d'entrée de conducteur extérieur (62) d'un disjoncteur de protection (6), dans lequel un contact électrique du contact de sortie (12) s'effectue avec le contact d'entrée (62) du disjoncteur de protection (6), de préférence de manière mécaniquement amovible au moyen d'une fixation par vis (61) du disjoncteur de protection (6).

10. Dispositif de mesure multiple (A) selon la revendication 9, dans lequel le contact électrique avec le conducteur neutre (N) s'effectue au moyen d'un pont de conducteur neutre (10) d'un premier dispositif de mesure multiple (A) à un second dispositif de mesure multiple (A') adjacent.

11. Disjoncteur de protection (6), de préférence un disjoncteur de protection de ligne, étendu de façon modulaire avec un dispositif de mesure multiple (A) selon l'une des revendications 1 à 4.

12. Disjoncteur de protection selon la revendication 11, dans lequel le capteur de courant (3) détecte en permanence le courant dans un circuit de courant principal (HSP) et dans lequel l'unité d'évaluation (4) est destinée à évaluer la valeur de courant détectée afin d'identifier un cas de panne, dans lequel en cas de panne, la valeur de courant détectée se situe au-dessus d'un multiple défini d'un courant nominal pendant une durée prédéfinie.

13. Disjoncteur de protection selon la revendication 12, dans lequel l'unité d'évaluation (4) commande, en cas de panne détectée, un interrupteur de déclenchement (7) dont l'activation déclenche un verrou de maintien (67) pour ouvrir et fixer un dispositif à contact (69) du disjoncteur de protection.

14. Disjoncteur de protection selon l'une des revendications 11 à 13, dans lequel l'unité d'évaluation (4) détecte un état d'un verrou de maintien (67), un état d'un système de coupe-circuit et de déclenchement (68) et une position de commutation d'un dispositif à contact (69) et les transmet par l'intermédiaire de l'interface de données sans contact.

15. Disjoncteur de protection (6) selon l'une des revendications 11 à 14 comportant en outre :
deux circuits de courant en parallèle qui sont branchés en série avec une bobine (65) d'un déclencheur magnétique (66), sous forme de circuits de courant principal et secondaire (HSP, NSP) par l'intermédiaire d'un dispositif à contact (69),
dans lequel en cas de panne, un verrou de maintien (67) se déclenche pour ouvrir et fixer le dispositif à contact (69) afin d'ouvrir un contact de commutation commun (C1) du dispositif à contact (69) afin de couper les circuits de courant principal et secondaire (HSP, NSP),
dans lequel le déclencheur magnétique (66) ouvre, en cas de court-circuit, un autre contact de commutation (C2) du dispositif à contact (69) afin de couper exclusivement le circuit de courant principal (HSP),
dans lequel dans le circuit de courant secondaire (NSP) est agencé un système de coupe-circuit et de déclenchement (68) qui coupe le circuit de courant secondaire (NSP) en cas de court-circuit et déclenche le verrou de maintien (67) pour ouvrir et fixer le dispositif à contact (69) afin de couper le contact de commutation commun (C1) pour les circuits de courant principal et secondaire (HSP, NSP),
dans lequel le capteur de courant (3) est branché en série avec la bobine (65) et le dispositif à contact (69).
